# EUROPEAN PATENT APPLICATION

(11) **EP 4 734 673 A1**
(43) Date of publication of application: **29.04.2026**
(21) Application number: 24831672.1
(22) Date of filing: 12.06.2024
(51) Int. Cl.: H05K 3/38, H05K 3/46

(54) **WIRING BOARD**

(30) Priority: 26.06.2023 JP 2023104222
(71) Applicant: Resonac Corporation, Tokyo 105-7325 (JP)
(72) Inventor: KINDAICHI, Rimpei, Tokyo 105-7325 (JP); URASHIMA, Kosuke, Tokyo 105-7325 (JP); NEMOTO, Hiroaki, Tokyo 105-7325 (JP); SONE, Keita, Tokyo 105-7325 (JP); YONEKURA, Motoki, Tokyo 105-7325 (JP)
(74) Representative: Strehl & Partner mbB
(86) International application number: PCT/JP2024/021340
(87) International publication number: WO 2025/004806

(57) **Abstract**

A wiring board including: a conductor wiring; an insulating layer having a first principal surface to which a surface of the conductor wiring closely adheres, and a second principal surface on a side opposite to the first principal surface; a magnetic layer positioned on a side of the insulating layer where the second principal surface is present; and a conductor layer positioned on a side of the magnetic layer opposite to the insulating layer, wherein the surface or the first principal surface has an arithmetic mean roughness of 0.1 µm or greater and 5.0 µm or less.

## Description

### TECHNICAL FIELD

This disclosure relates to a wiring board.

### BACKGROUND ART

As one factor of electric signal attenuation in a circuit board, it is known that a conductor layer including wiring has a large surface roughness. In particular, when a high-frequency electric signal is used, transmission loss due to the large surface roughness of the conductor layer is remarkable. It is particularly desirable to reduce the surface roughness of the conductor layer in what is generally referred to as a high-frequency circuit board for use in servers where high-speed transmission of electric signals is required (for example, see PTL 1).

### CITATION LIST

### PATENT LITERATURE

PTL 1: Japanese Patent Application Laid-Open Publication No. 2021-016006

### SUMMARY OF THE INVENTION

### TECHNICAL PROBLEM

When conductor wiring is in close adhesion with an insulating layer, the greater the surface roughness of the conductor wiring or the insulating layer, the greater the close adhesiveness between the conductor wiring and the insulating layer owing to the anchor effect. However, the greater the surface roughness of the conductor wiring or the insulating layer, the greater the scattering loss may be. The scattering loss is a phenomenon in which an electric signal is lost in the form of heat due to being scattered by a roughened part of the surface of conductor wiring or the interface between the conductor wiring and an insulating layer.

The present disclosure provides a wiring board in which close adhesiveness between conductor wiring and an insulating layer and inhibition of scattering loss can both be satisfied.

### SOLUTION TO THE PROBLEM

A wiring board according to a first aspect includes:
conductor wiring;
an insulating layer having a first principal surface to which a surface of the conductor wiring closely adheres, and a second principal surface on a side opposite to the first principal surface;
a magnetic layer positioned on a side of the insulating layer where the second principal surface is present; and
a conductor layer positioned on a side of the magnetic layer opposite to the insulating layer,
wherein the surface or the first principal surface has an arithmetic mean roughness of 0.1 µm or greater and 5.0 µm or less.

A second aspect is the wiring board according to the first aspect,
wherein the magnetic layer has a thickness of 0.1 µm or greater and 100 µm or less.

A third aspect is the wiring board according to the first or second aspect,
wherein the magnetic layer has a relative magnetic permeability of 1.5 or greater at a frequency of 30 GHz or higher.

A fourth aspect is the wiring board according to any one of the first to third aspects,
wherein the magnetic layer has a part that is wider than the conductor wiring.

A fifth embodiment is the wiring board according to any one of the first to fourth embodiments,
wherein the insulating layer has a part that is equal to or smaller than the magnetic layer in thickness.

A sixth embodiment is the wiring board according to any one of the first to fifth embodiments, further including:
a second insulating layer between the magnetic layer and the conductor layer.

### ADVANTAGEOUS EFFECTS OF THE INVENTION

According to the present disclosure, it is possible to provide a wiring board in which close adhesiveness between the conductor wiring and the insulating layer and inhibition of scattering loss can both be satisfied.

### BRIEF DESCRIPTION OF THE DRAWINGS

[FIG. 1] FIG. 1 is a diagram illustrating breakdown of transmission loss.
[FIG. 2] FIG. 2 is an oblique view showing an example of the configuration of a wiring board according to a first embodiment.
[FIG. 3] FIG. 3 is a cross-sectional view showing an example of the configuration of the wiring board according to the first embodiment.
[FIG. 4] FIG. 4 is a diagram showing an example of a current distribution in conductor wiring in the absence of a magnetic layer.
[FIG. 5] FIG. 5 is a diagram showing an example of a current distribution in conductor wiring in the presence of a magnetic layer.
[FIG. 6] FIG. 6 is a cross-sectional view showing an example of the configuration of a wiring board according to a second embodiment.
[FIG. 7] FIG. 7 is a diagram illustrating an example of the concept of a method for evaluating scattering loss.
[FIG. 8] FIG. 8 is a simulation diagram showing an example of scattering loss calculated using the evaluation method of FIG. 7.
[FIG. 9] FIG. 9 is a table showing an example of the calculation result of scattering loss of the wiring board of the first embodiment and a wiring board of a comparative embodiment.
[FIG. 10] FIG. 10 is a graph showing an example of the calculation result of scattering loss of the wiring board of the first embodiment and a wiring board of a comparative embodiment.
[FIG. 11] FIG. 11 is a graph showing an example of the calculation result of scattering loss of the wiring board of the first embodiment and a wiring board of a comparative embodiment.
[FIG. 12] FIG. 12 is a graph showing an example of the calculation result of scattering loss of the wiring board of the second embodiment and a wiring board of a comparative embodiment.

### DETAILED DESCRIPTION OF THE INVENTION

Each embodiment will be described below. In the present specification and the drawings, components having substantially the same functional configuration are denoted by the same reference numerals, so that redundant explanations will be omitted.

For facilitating understanding, the components in the drawings might not be to scale. Directions such as parallel, right angle, orthogonal, horizontal, vertical, up, down, left, and right directions and the like are allowed to deviate to a degree until which the workings and effects of the embodiments are not impaired. The X-axis direction, the Y-axis direction, and the Z-axis direction represent a direction parallel to the X-axis, a direction parallel to the Y-axis, and a direction parallel to the Z-axis, respectively. The X-axis direction, the Y-axis direction, and the Z-axis direction are orthogonal to each other. The XY plane, the YZ plane, and the ZX plane represent an imaginary plane parallel to the X-axis direction and the Y-axis direction, an imaginary plane parallel to the Y-axis direction and the Z-axis direction, and an imaginary plane parallel to the Z-axis direction and the X-axis direction, respectively.

The term "layer" may include not only a structure having a shape formed on an entire surface, but also a structure having a shape formed on a part when viewed in a plan view. The materials exemplified below may be used alone or in combination of two or more unless otherwise particularly noted. The content of each component in a composition means, unless otherwise particularly noted, the total amount of a plurality of substances present in the composition, in a case where a plurality of substances falling within the component are present in the composition. The numerical range indicated by the term "to" indicates a range including the numerical values before and after "to" as the minimum value and the maximum value, respectively. Regarding numerical ranges specified stepwise in this specification, the upper limit or lower limit of the numerical range of one step may be replaced with the upper limit or lower limit of the numerical range of another step. Regarding a numerical range specified in this specification, the upper limit or lower limit of the numerical range may be replaced with a value shown in an Example.

### <Transmission Loss>

First, transmission loss will be described. Transmission loss refers to the degree of attenuation of a signal such as electricity, light, or sound in a communication path in accordance with distance or the like. In the case of a wiring board on which a transmission line such as a microstrip line is formed, the higher the frequency of a signal, the greater the transmission loss.

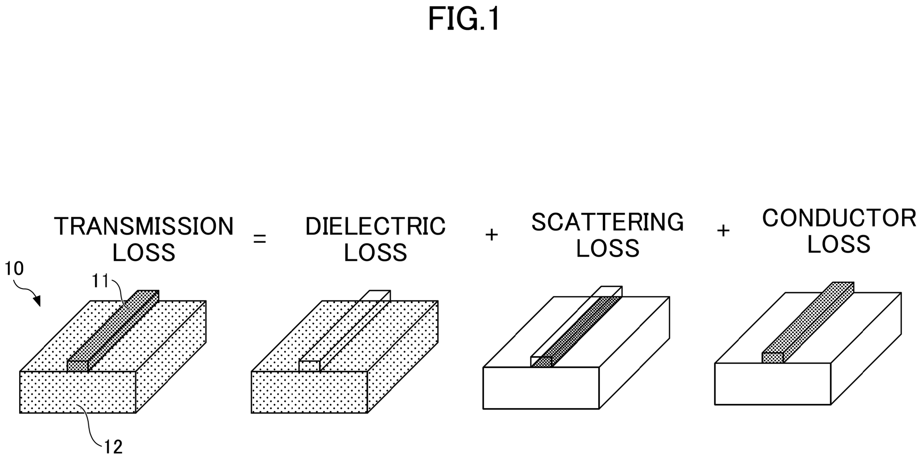

FIG. 1 is a diagram illustrating the breakdown of transmission loss. The transmission loss is equal to the sum of dielectric loss, scattering loss, and conductor loss.

Dielectric loss is a phenomenon in which a part of electric energy supplied by an alternating electric field is lost in a dielectric material in the form of heat when the alternating electric field is applied to the dielectric material. Dielectric loss depends on dielectric properties of the dielectric material. Specifically, the magnitude of the dielectric loss varies depending on the dielectric loss tangent and the dielectric constant. The higher the frequency, the greater the dielectric loss. The greater the dielectric loss tangent or the dielectric constant, the greater the dielectric loss.

In the case of a wiring board 10, conductor wiring 11 is formed over the substrate 12, which is a dielectric material, on the upper side thereof, or on the upper and lower sides thereof. When an alternating current signal flows through the conductor wiring 11, an alternating electric field is applied to the substrate 12, which is a dielectric material. When a part of the energy of the signal is lost in the substrate 12 as a dielectric loss, the energy of the signal is attenuated proportionately.

The conductor loss is a phenomenon in which a part of the energy of a signal transmitted through the conductor wiring 11 is lost in the conductor wiring 11 in the form of Joule heat due to the resistance or the skin effect of the conductor wiring 11. When a current, which is a signal, is a direct current, the higher the resistance of the conductor wiring 11, the greater the Joule heat. Therefore, when a DC current signal is transmitted through the conductor wiring 11, the higher the resistance of the conductor wiring 11, the greater the conductor loss. On the other hand, when a current, which is a signal, is an alternating current, the higher the frequency of the signal, the shallower the skin depth due to the skin effect. The skin depth is an indicator of how far a current flows from the surface of the conductor. In the case of an AC signal, the shallower the skin depth, the higher the resistance of the conductor wiring 11. Therefore, when an AC current signal is transmitted through the conductor wiring 11, the higher the frequency of the signal, the greater the conductor loss.

The scattering loss is a phenomenon in which a signal transmitted through the conductor wiring 11 when a high-frequency electric field is applied to the conductor wiring 11 is lost in the form of heat due to being scattered by a roughened part of the surface of the conductor wiring 11 or of the interface between the conductor wiring 11 and the substrate 12. The roughened part is a part of the surface or the interface that is uneven.

In the case of the wiring board 10, the surface of the conductor wiring 11 or the interface between the conductor wiring 11 and the substrate 12 is often roughened in order to improve the close adhesiveness between the conductor wiring 11 and the substrate 12. On the other hand, the higher the signal frequency band, the greater the skin effect. Therefore, there may be a case where scattering due to the roughened part of the surface of the conductor wiring 11 or of the interface between the conductor wiring 11 and the substrate 12 is a major factor that affects the transmission loss.

There is also a way of thinking that a loss due to the roughening treatment of the surface or the interface of a conductor is encompassed within the conductor loss, as a loss due to the skin effect. However, it is considered easier to understand the conductor loss, for which a calculation formula has already been established and that takes the skin depth into consideration as an increase in the resistance, and the loss due to the roughening treatment, for which a calculation formula is currently under discussion, by defining them separately. Therefore, the present disclosure treats the scattering loss as a loss different from the conductor loss.

### <First Embodiment>

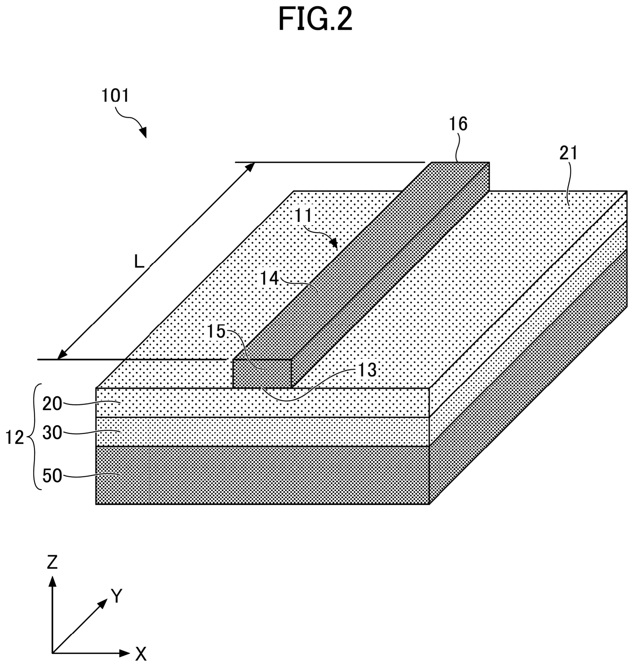

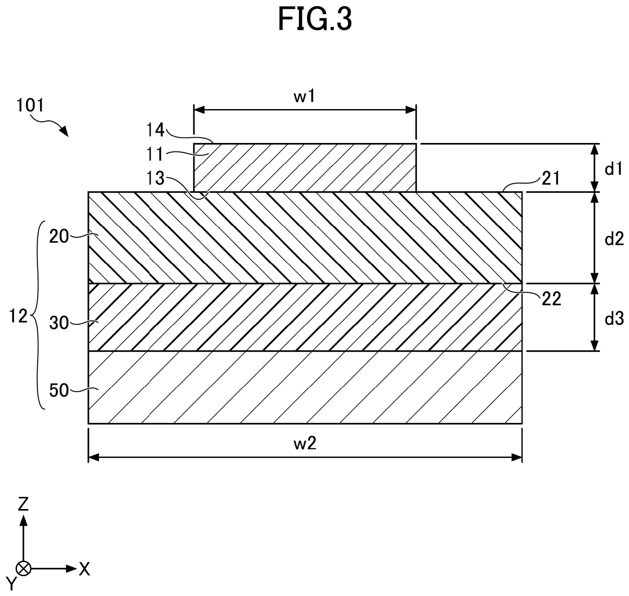

FIG. 2 is an oblique view showing an example of the configuration of the wiring board according to the first embodiment. FIG. 3 is a cross-sectional view showing an example of the configuration of the wiring board according to the first embodiment. FIGS. 2 and 3 may show examples of the configuration of a partially cut-out part of the wiring board of the first embodiment. This also applies to the drawings showing other embodiments described later. The first embodiment will be described below with reference to FIGS. 2 and 3.

A wiring board 101 shown in FIGS. 2 and 3 includes a substrate 12 and a conductor wiring 11. The substrate 12 includes an insulating layer 20, a magnetic layer 30, and a conductor layer 50.

The conductor wiring 11 is a conductive signal line extending in the Y-axis direction. The conductor wiring 11 has an input end 15 facing the negative Y-axis direction, an output end 16 facing the positive Y-axis direction, an upper surface 14 facing the positive Z-axis direction, and a lower surface 13 facing the negative Z-axis direction. The lower surface 13 is a surface in close adhesion with a first principal surface 21 of the insulating layer 20.

A high-frequency current signal transmitted through the conductor wiring 11 flows from the input end 15 to the output end 16. The conductor wiring 11 has a wiring length L in the Y-axis direction from the input end 15 to the output end 16, a wiring width w1 in the X-axis direction from one side surface to the other side surface, and a wiring thickness d1 in the Z-axis direction from the lower surface 13 to the upper surface 14.

The conductor wiring 11 is a signal line serving as a transmission line formed on the wiring board 101. Examples of the transmission line include a microstrip line, a coplanar line, a strip line, and the like. In FIGS. 2 and 3, the conductor layer 50 functions as a ground pattern of the transmission line. The conductor wiring 11 is formed of a conductive metal such as copper.

The insulating layer 20 is an insulator extending along the XY plane. The insulating layer 20 has a first principal surface 21 facing the positive Z-axis direction and a second principal surface 22 facing the negative Z-axis direction. The second principal surface 22 is a surface opposite to the first principal surface 21 in the Z-axis direction. The insulating layer 20 has a width w2 along the X-axis direction, a length L along the Y-axis direction, and a thickness d2 along the Z-axis direction.

The thickness d2 of the insulating layer 20 can be appropriately set in accordance with the wiring thickness d1 of the conductor wiring 11 to be formed, and may be, for example, 30 µm or less, 20 µm or less, 10 µm or less, 5 µm or less, or 3 µm or less. The thickness d2 of the insulating layer 20 may be 1 µm or greater from the viewpoint of insulation reliability.

The magnetic layer 30 is a magnetic material extending along the XY plane and has a relative magnetic permeability greater than 1. The magnetic layer 30 is positioned on the second principal surface 22 side of the insulating layer 20 and may contact the second principal surface 22. Since the insulating layer 20 is sandwiched between the magnetic layer 30 and the conductor wiring 11, the magnetic layer is located at a position separated from the conductor wiring 11 without contacting the conductor wiring 11. The magnetic layer 30 has a width w2 along the X-axis direction, a length L along the Y-axis direction, and a thickness d3 along the Z-axis direction. The magnetic layer 30 is located between the insulating layer 20 and the conductor layer 50.

The magnetic layer 30 is, for example, an insulating magnetic layer including an insulator containing a magnetic material. The insulator containing a magnetic material is also referred to as a magnetic insulator. The composition for forming the insulating magnetic layer will be described later.

The conductor layer 50 is located on a side of the magnetic layer 30 opposite to the insulating layer 20. The conductor layer 50 is a conductor extending along the XY plane. The conductor layer 50 functions as a ground pattern of the transmission line formed on the wiring board 101. The conductor layer 50 may be the same type of conductor as the conductor wiring 11 or a different type of conductor from the conductor wiring 11. The conductor layer 50 may contact the lower surface of the magnetic layer 30.

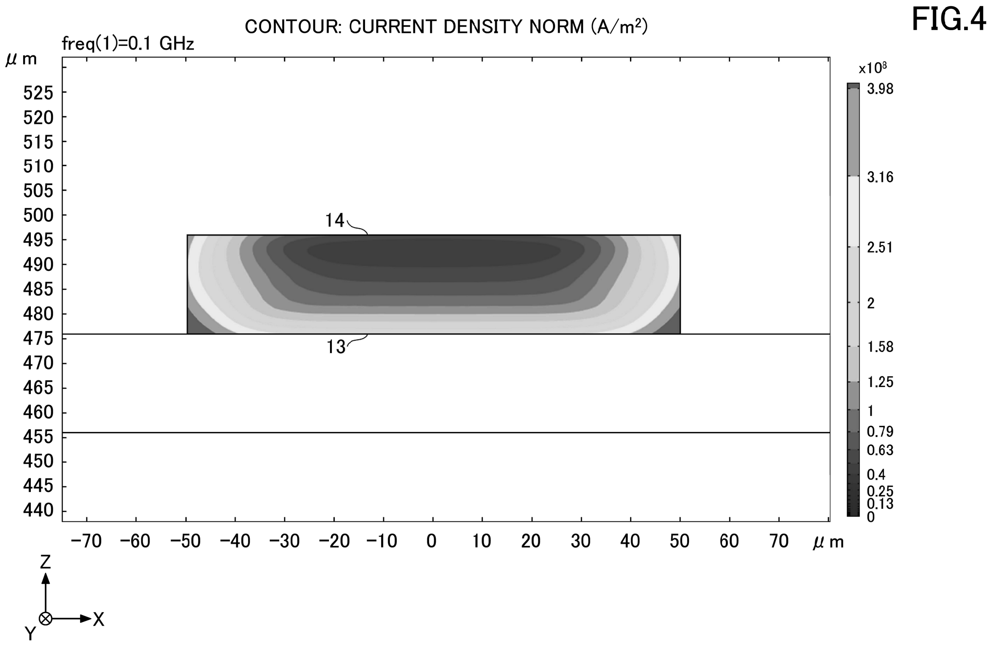

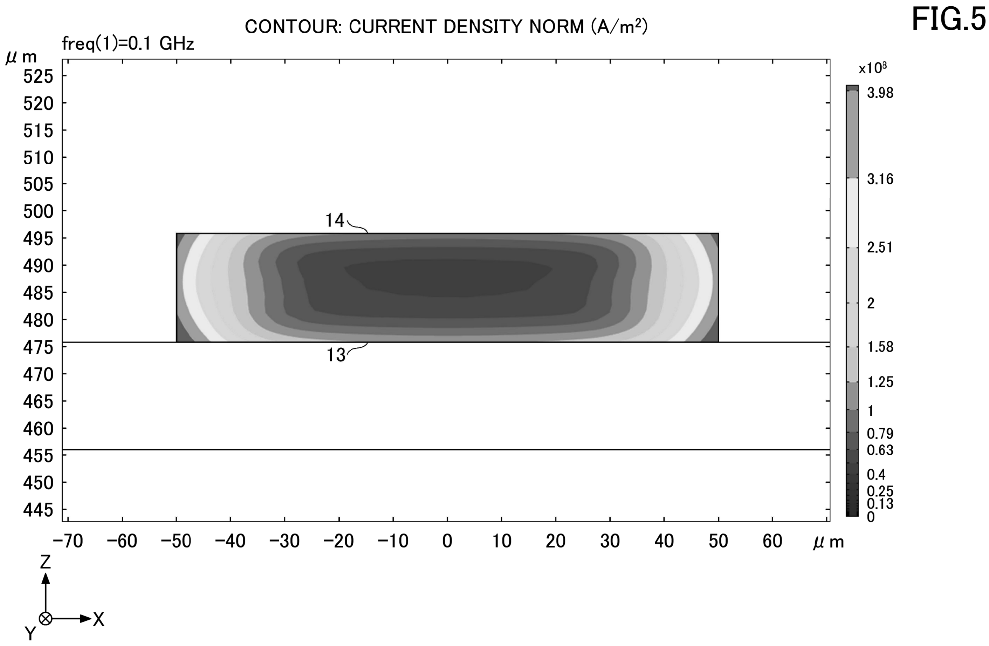

Here, the function of the magnetic layer 30 will be described with reference to FIGS. 4 and 5. FIG. 4 is a diagram showing an example of a current distribution in the conductor wiring 11 when the magnetic layer 30 is not present. FIG. 5 is a diagram showing an example of a current distribution in the conductor wiring 11 when the magnetic layer 30 is present. FIGS. 4 and 5 are contour diagrams showing the current density in a ZX cross-section of the conductor wiring 11 through which a high-frequency current having a frequency of 0.1 GHz flows. The lower surface 13 of the conductor wiring 11 contacts the first principal surface 21 of the insulating layer 20.

When a high-frequency current flows through the conductor wiring 11, the current density in the conductor wiring 11 is higher at a position closer to the surface of the conductor wiring 11 due to the skin effect. In the case of FIG. 4 without the magnetic layer 30, the current density along the lower surface 13 relatively close to the ground pattern becomes higher. On the other hand, in the case of FIG. 5 with the magnetic layer 30, the presence of the magnetic layer 30 causes the current density along the lower surface 13 to be lower and causes the current density along the side surfaces, the upper surface 14, and the upper corners of the conductor wiring 11 to be higher. Since the current density along the lower surface 13 becomes lower, scattering loss that may be caused by a roughened part of the lower surface 13 of the conductor wiring 11 or the interface between the lower surface 13 and the first principal surface 21 is inhibited.

In the wiring board 101 of the first embodiment shown in FIGS. 2 and 3, the lower surface 13 of the conductor wiring 11 or the first principal surface 21 of the insulating layer 20 has an arithmetic mean roughness of 0.1 µm or greater and 5.0 µm or less. The arithmetic mean roughness is also referred to as Ra.

When Ra is 0.1 µm or greater, the lower surface 13 or the first principal surface 21 has a greater surface roughness than when Ra is less than 0.1 µm. Therefore, the close adhesiveness between the conductor wiring 11 and the insulating layer 20 is enhanced. On the other hand, when Ra is 5.0 µm or less, the lower surface 13 or the first principal surface 21 has a less surface roughness than when Ra is greater than 5.0 µm. Therefore, scattering loss that may be caused by the roughened part of the lower surface 13 of the conductor wiring 11 or of the interface between the lower surface 13 and the first principal surface 21 is inhibited. Thus, since the lower surface 13 of the conductor wiring 11 or the first principal surface 21 of the insulating layer 20 has an arithmetic mean roughness of 0.1 µm or greater and 5.0 µm or less, the close adhesiveness between the conductor wiring 11 and the insulating layer 20 and inhibition of scattering loss that may be caused between the conductor wiring 11 and the insulating layer 20 can both be satisfied.

In terms of improving the close adhesiveness of the lower surface 13 or the first principal surface 21, Ra is preferably 0.1 µm or greater, more preferably 0.2 µm or greater, and yet more preferably 0.5 µm or greater. In terms of inhibiting scattering loss that may be caused between the conductor wiring 11 and the insulating layer 20, Ra is preferably 5.0 µm or less, more preferably 3.0 µm or less, and yet more preferably 1.0 µm or less.

Since the lower surface 13 has a part where Ra is 0.1 µm or greater and 5.0 µm or less in a region overlapping the first principal surface 21 when viewed in a plan view of the wiring board 101 in the Z-axis direction, securing of close adhesiveness and inhibition of scattering loss can both be satisfied. Since the first principal surface 21 has a part where Ra is 0.1 µm or greater and 5.0 µm or less in a region overlapping the lower surface 13 when viewed in a plan view of the wiring board 101 in the Z-axis direction, securing of close adhesiveness and inhibition of scattering loss can both be satisfied.

Ra is measured according to, for example, Japanese Industrial Standards (JIS) B0601-2001. The average line for measuring Ra is, for example, a line extending along the Y-axis direction in which a current signal flows through the conductor wiring 11.

When the magnetic layer 30 has a thickness d3 of 0.1 µm or greater and 100 µm or less, scattering loss can be inhibited. In terms of inhibiting scattering loss, the thickness d3 may be 0.2 µm or greater and 80 µm or less, and may be 0.5 µm or greater and 60 µm or less.

The magnetic layer 30 having a relative magnetic permeability of 1.5 or greater can inhibit scattering loss when a signal having a frequency of 30 GHz or higher is transmitted through the conductor wiring 11. In terms of inhibiting scattering loss, the relative magnetic permeability of the magnetic layer 30 may be 2 or greater, 3 or greater, 10 or greater, or 20 or greater for transmission of a signal having a frequency of 30 GHz or higher through the conductor wiring 11. The upper limit of the relative magnetic permeability of the magnetic layer 30 is not particularly limited, and is, for example, 1,000 or less. The frequency of a signal transmitted through the conductor wiring 11 is not particularly limited, and is, for example, 100 GHz or lower.

When the magnetic layer 30 has a part wider than the conductor wiring 11, scattering loss can be inhibited. The magnetic layer 30 illustrated in FIGS. 2 and 3 has a width w2 greater than the wiring width w1 of the conductor wiring 11.

When the insulating layer 20 has a part where the thickness is equal to the thickness d3 of the magnetic layer 30 or is less than the thickness d3 of the magnetic layer 30, scattering loss can be inhibited. For example, the insulating layer 20 has a thickness d2 equal to the thickness d3 of the magnetic layer 30 or greater than the thickness d3.

### <Second Embodiment>

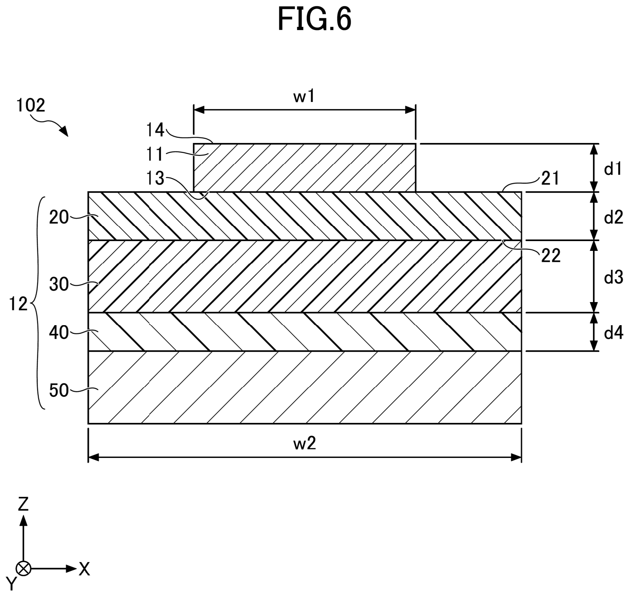

FIG. 6 is a cross-sectional view showing an example of the configuration of a wiring board according to the second embodiment. In the second embodiment, description of the same configuration, workings, and effects as those of the first embodiment will be omitted or simplified by referring to the foregoing description.

A wiring board 102 according to the second embodiment shown in FIG. 6 differs from the wiring board 101 in further including an insulating layer 40 in addition to the components of the wiring board 101 according to the first embodiment shown in FIG. 3. The wiring board 102 shown in FIG. 6 includes the insulating layer 40 between the magnetic layer 30 and the conductor layer 50.

The insulating layer 40 is an example of a second insulating layer, and is an insulator extending along the XY plane. The insulating layer 40 has a thickness d4 along the Z-axis direction. The insulating layer 40 may be the same type of insulator as the insulating layer 20 or a different type of insulator from the insulating layer 20. The insulating layer 40 may contact the lower surface of the magnetic layer 30. The insulating layer 40 may contact the upper surface of the conductor layer 50.

The insulating layer 40 is positioned such that the magnetic layer 30 is sandwiched between the insulating layer 20 and the insulating layer 40. The insulating layer 40 may contact the magnetic layer 30. The insulating layer 40 has a width w2 in the X-axis direction and a length L in the Y-axis direction.

As the insulating layer 40, for example, a substrate obtained by laminating some publicly-known prepregs and subjecting it to pressurization heating treatment can be used. As such a prepreg, a prepreg produced by a publicly-known method of impregnating a fiber base material (reinforced fiber) such as glass fiber, organic fiber, or the like with prepared resin varnish can be used. An example thereof is a glass epoxy composite substrate. A metal substrate or a ceramic substrate may be used as the core material to which the prepreg is laminated. Further, a publicly-known low-dielectric substrate such as a substrate using a low-dielectric resin material such as a polyimide resin, a fluorine resin, a liquid crystal polymer (LCP), and the like can be used as the insulating layer 40.

Examples of the resin material forming the insulating layer 40 include resins such as thermosetting resins and thermoplastic resins. One resin material may be used alone or two or more types of resin materials may be used in combination.

Examples of the thermosetting resin include a polycarbonate resin, a thermosetting polyimide resin, a thermosetting fluorinated polyimide resin, an epoxy resin, a phenol resin, a urea resin, a melamine resin, a diallyl phthalate resin, a silicone resin, a thermosetting urethane resin, a fluororesin, a liquid crystal polymer, and the like. Examples of the fluororesin include a polymer of a fluorine-containing olefin, such as polytetrafluoroethylene (PTFE).

Examples of the thermoplastic resin include olefin resins, acrylic resins, polystyrene resins, polyester resins, polyacrylonitrile resins, maleimide resins, polyvinyl acetate resins, ethylene-vinyl acetate copolymers, polyvinyl alcohol resins, polyamide resins, polyvinyl chloride resins, polyacetal resins, polyphenylene oxide resins, polyphenylene sulfide resins, polysulfone resins, polyether sulfone resins, polyether ether ketone resins, polyallyl sulfone resins, thermoplastic polyimide resins, thermoplastic fluorinated polyimide resins, thermoplastic urethane resins, polyether imide resins, polymethylpentene resins, cellulose resins, liquid crystal polymers, and ionomers.

The insulating layer 40 may include a single layer or multiple layers. The insulating layer 40 may have an adhesive layer on its surface.

The thickness of the insulating layer 40 may be 10 µm to 1 mm.

In the wiring board 102 of the second embodiment shown in FIG. 6, the lower surface 13 of the conductor wiring 11 or the first principal surface 21 of the insulating layer 20 has an arithmetic mean roughness of 0.1 µm or greater and 5.0 µm or less. Thus, the close adhesiveness between the conductor wiring 11 and the insulating layer 20 and inhibition of scattering loss that may be caused between the conductor wiring 11 and the insulating layer 20 can both be satisfied.

### <Method for Evaluating Scattering Loss>

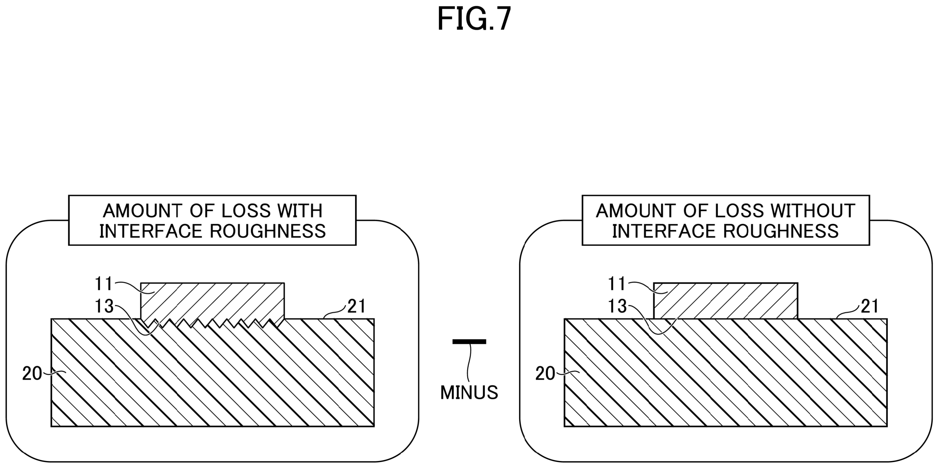

FIG. 7 is a diagram illustrating an example of the concept of the method for evaluating a scattering loss. The method for calculating the magnitude of a scattering loss has not been established at present. Therefore, in this specification, as shown in FIG. 7, the amount of loss obtained by subtracting the amount of transmission loss calculated when there is no roughness at an interface from the amount of transmission loss calculated when there is roughness at the interface is defined as the magnitude of scattering loss caused by the roughened part of the interface.

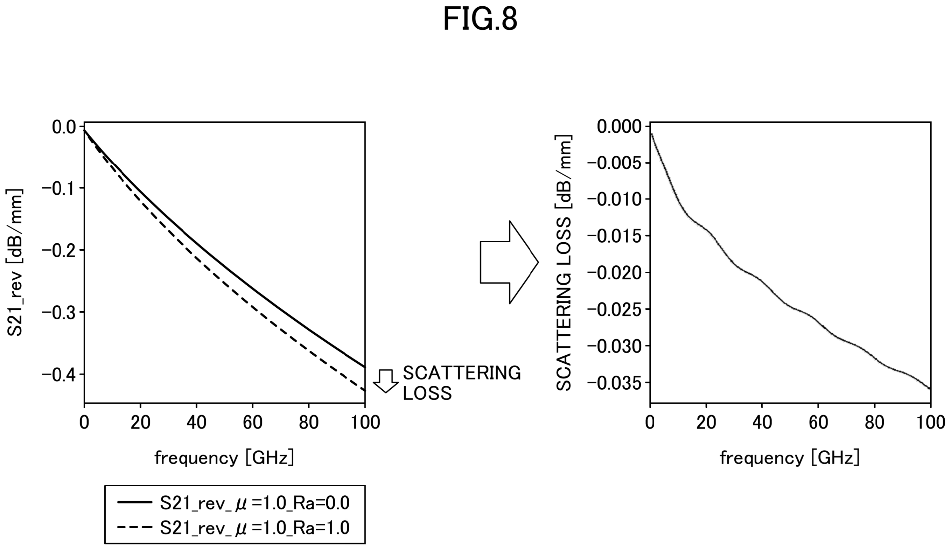

FIG. 8 is a simulation diagram showing an example of scattering loss calculated using the evaluation method of FIG. 7. S21_rev is a normalized value (= amount of loss) of S21 in consideration of reflection, and is calculated according to "S21²/(1-S11²)". S21 is one of the S parameters, and represents a coefficient of transmission from the input end 15 to the output end 16 of the conductor wiring 11. S11 is one of the S parameters, and represents a coefficient of input reflection indicating a ratio of a signal reflected at the input end 15 to a signal input into the input end 15 of the conductor wiring 11. The smaller S21_rev, the greater the transmission loss of the conductor wiring 11. "S21_rev_µ=1.0_Ra=0.0" represents a case where the relative magnetic permeability of the magnetic layer 30 is 1.0 and Ra is 0.0, that is, an example of a transmission loss calculated when there is no interface roughness. "S 21_rev_p=1.0_Ra=1.0" represents a case where the relative magnetic permeability of the magnetic layer 30 is 1.0 and Ra is 1.0, that is, an example of a transmission loss calculated when there is interface roughness. A value obtained by subtracting the amount of the transmission loss "S21_rev_p=1.0_Ra=0.0" from the amount of the transmission loss "S21_rev_p=1.0_Ra=1.0" corresponds to the magnitude of the scattering loss caused by the roughened part of the interface.

### <Example 1 of Scattering Loss Evaluation Result>

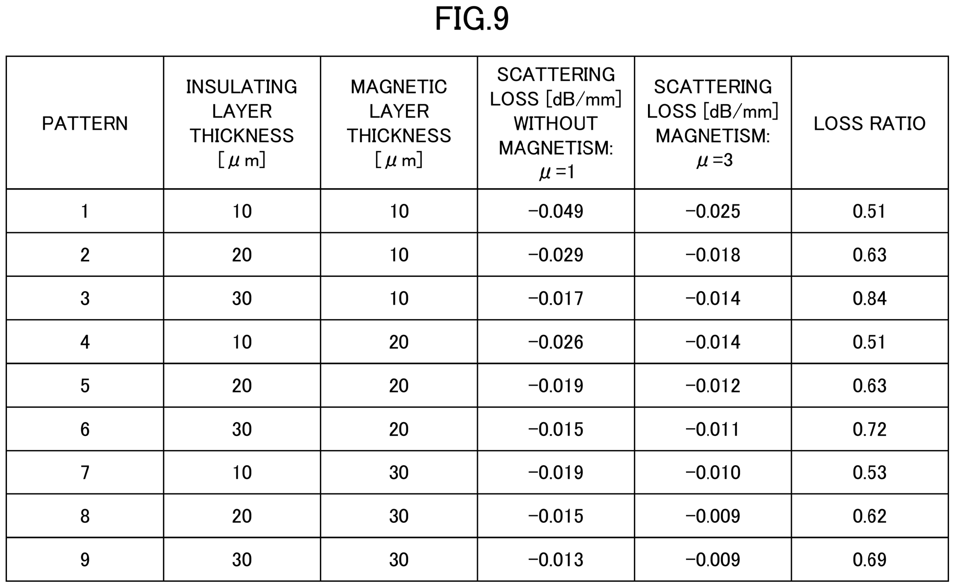

FIG. 9 is a table showing an example of the result of calculating scattering loss of the wiring board of the first embodiment and a wiring board of a comparative embodiment using the evaluation method shown in FIGS. 7 and 8. "Scattering loss [dB/mm] magnetism: µ=3" represents the scattering loss of the wiring board 101 of the first embodiment shown in FIG. 3 when the relative magnetic permeability µ of the magnetic layer 30 is 3. "Scattering loss [dB/mm] without magnetism: µ=1" represents the scattering loss of the wiring board of the comparative embodiment in which no magnetic layer 30 exists. The wiring board of the comparative embodiment corresponds to the calculation result when the relative magnetic permeability µ of the magnetic layer 30 of the wiring board 101 of the first embodiment shown in FIG. 3 is set to 1. "Loss ratio" represents the degree of reduction in the scattering loss of the wiring board 101 of the first embodiment relative to the scattering loss of the wiring board of the comparative embodiment. The smaller the loss ratio, the higher the effect of reducing the scattering loss.

FIG. 9 shows the scattering loss calculated for each of dimensional examples of patterns 1 to 9. The dimensions and parameters for the calculations that are shown in FIG. 9 are as follows.
Wiring width w1: 100 µm
Wiring thickness d1: 20 µm
Thickness d2 of the insulating layer 20: 10 µm, 20 µm, or 30 µm
Thickness d3 of the magnetic layer 30: 10 µm, 20 µm, or 30 µm
Dielectric loss tangent of the insulating layer 20: 0.03@60 GHz
Relative permittivity of the insulating layer 20: 5@60 GHz
Ra of the lower surface 13 or the first principal surface 21: 0.5 µm

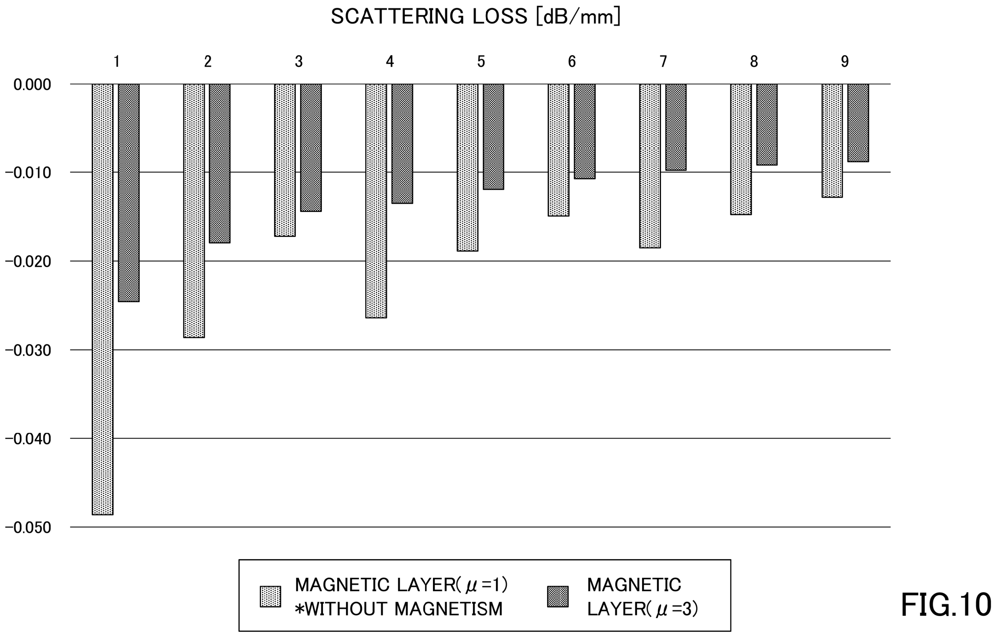

FIG. 10 is a graph showing an example of calculation results of scattering loss of the wiring board of the first embodiment and the wiring board of the comparative embodiment. FIG. 10 shows calculation results of scattering loss simulated for each of the dimensional examples of patterns 1 to 9 shown in FIG. 9. As shown in FIGS. 9 and 10, in any of the patterns 1 to 9, scattering loss can be better inhibited when the magnetic layer 30 is provided than when no magnetic layer 30 is provided.

In FIG. 9, patterns 1, 2, and 3 are calculation groups in which the thickness d2 of the insulating layer 20 is set to different values while the thickness d3 of the magnetic layer 30 is fixed at 10 µm. Patterns 4, 5, and 6 are calculation groups in which the thickness d2 of the insulating layer 20 is set to different values while the thickness d3 of the magnetic layer 30 is fixed at 20 µm. Patterns 7, 8, and 9 are calculation groups in which the thickness d2 of the insulating layer 20 is set to different values while the thickness d3 of the magnetic layer 30 is fixed at 30 µm. In any calculation group, the effect of inhibiting scattering loss is enhanced by the thickness d2 of the insulating layer 20 being equal to the thickness d3 of the magnetic layer 30 or being smaller than the thickness d3.

### <Example 2 of Scattering Loss Evaluation Result>

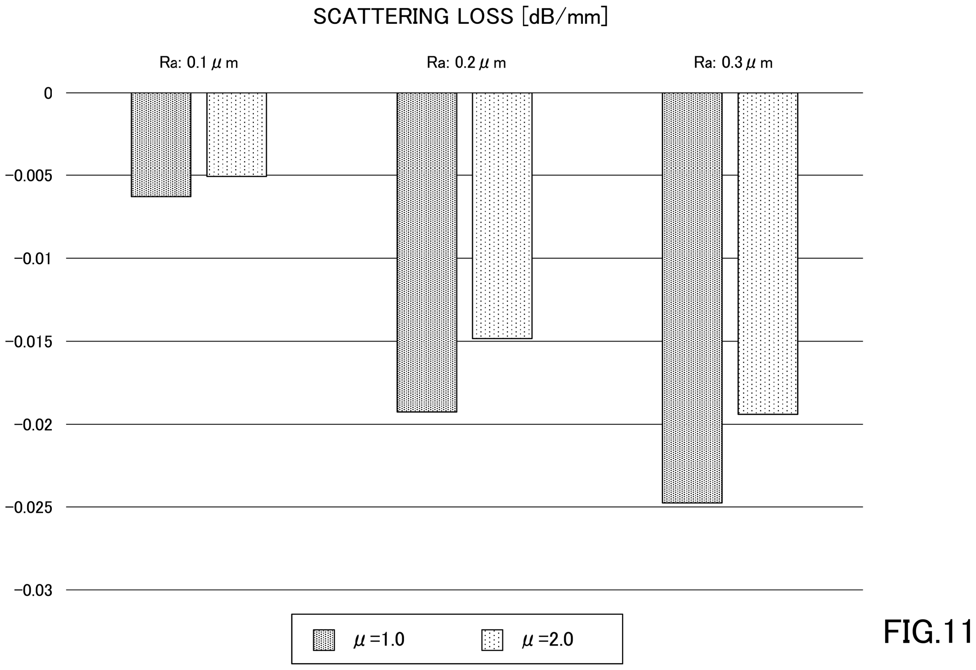

FIG. 11 is a graph showing an example of the calculation result of the scattering loss of the wiring board of the first embodiment and the wiring board of the comparative embodiment. "µ=2.0" represents the scattering loss of the wiring board 101 of the first embodiment shown in FIG. 3 when the relative magnetic permeability µ of the magnetic layer 30 is 2.0. "µ =1.0" represents the scattering loss of the wiring board of the comparative embodiment in which no magnetic layer 30 exists. The wiring board of the comparative embodiment corresponds to the calculation result when the relative magnetic permeability µ of the magnetic layer 30 of the wiring board 101 of the first embodiment shown in FIG. 3 is set to 1.0.

FIG. 11 shows the scattering loss calculated at three types of Ra. The respective dimensions and parameters for the calculations that are shown in FIG. 11 are as follows.
Wiring width w1: 100 µm
Wiring thickness d1: 20 µm
Thickness d2 of the insulating layer 20: 20 µm
Thickness d3 of the magnetic layer 30: 10 µm
Dielectric loss tangent of the insulating layer 20: 0.03@60 GHz
Relative permittivity of the insulating layer 20: 5@60 GHz
Ra of the lower surface 13 or the first principal surface 21: 0.1 µm, 0.2 µm, or 0.3 µm

As shown in FIG. 11, it can be confirmed that the scattering loss can be better inhibited when the magnetic layer 30 is provided than when no magnetic layer 30 is provided, regardless of whether the Ra is 0.1 µm, 0.2 µm, or 0.3 µm.

### <Example 3 of Scattering Loss Evaluation Result>

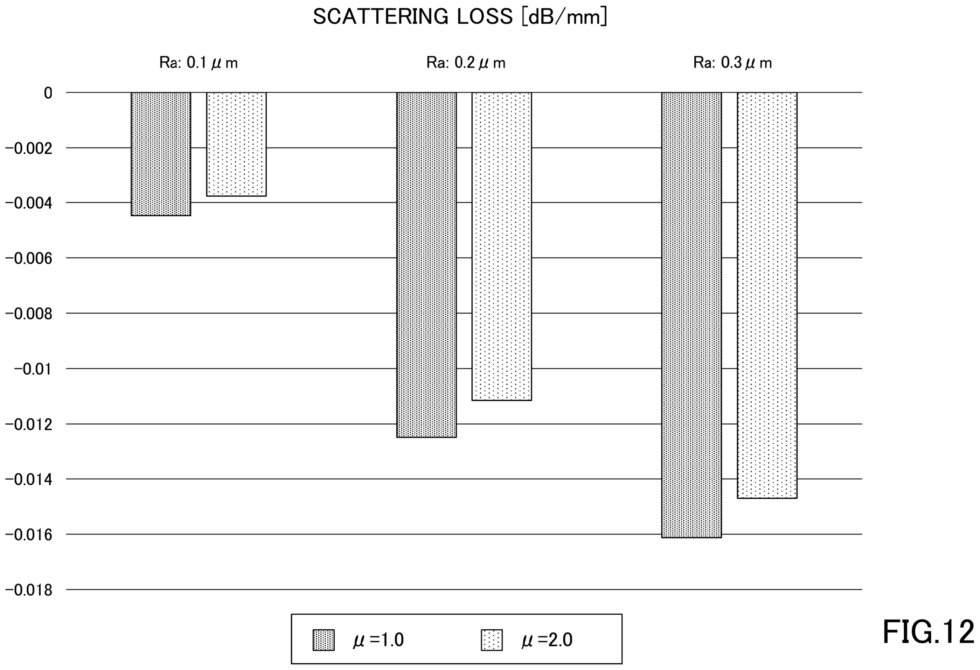

FIG. 12 is a graph showing an example of the calculation results of scattering loss of the wiring board of the second embodiment and the wiring board of the comparative embodiment. "µ=2.0" represents the scattering loss of the wiring board 102 of the second embodiment shown in FIG. 6 when the relative magnetic permeability µ of the magnetic layer 30 is 2.0. "µ =1.0" represents the scattering loss of the wiring board of the comparative embodiment in which no magnetic layer 30 exists. The wiring board of the comparative embodiment corresponds to the calculation result when the relative magnetic permeability µ of the magnetic layer 30 of the wiring board 102 of the second embodiment shown in FIG. 6 is set to 1.0.

FIG. 12 shows the scattering loss calculated at three types of Ra. The dimensions and parameters for the calculations that are shown in FIG. 12 are as follows.
Wiring width w1: 100 µm
Wiring thickness d1: 20 µm
Thickness d2 of the insulating layer 20: 20 µm
Thickness d3 of the magnetic layer 30: 10 µm
Thickness d4 of the insulating layer 40: 10 µm
Dielectric loss tangent of the insulating layer 20: 0.03@60 GHz
Relative permittivity of the insulating layer 20: 5@60 GHz
Ra of the lower surface 13 or the first principal surface 21: 0.1 µm, 0.2 µm, or 0.3 µm

As shown in FIG. 12, it can be confirmed that the scattering loss can be better inhibited when the magnetic layer 30 is provided than when no magnetic layer 30 is provided, regardless of whether the Ra is 0.1 µm, 0.2 µm, or 0.3 µm.

### <Composition for Forming Insulating Magnetic Layer>

The composition for forming the insulating magnetic layer is a curable composition containing a magnetic material. The composition for forming the insulating magnetic layer can be formed by, for example, mixing a binder resin varnish and a magnetic powder.

The magnetic material may be, for example, at least one type of magnetic powder selected from the group consisting of simple substances of metals, alloys, and metal compounds. An alloy may contain at least one type selected from the group consisting of solid solutions, eutectic crystals, amorphous metals, and intermetallic compounds. An example of a metal compound is a metal oxide.

The magnetic material may be a metal oxide, an amorphous metal, or a metallic glass magnetic powder from the viewpoint of insulating properties. An example of the metal oxide is a ferrite. Examples of the amorphous metal include Fe-based nanocrystalline alloys and Co-based nanocrystalline alloys.

The magnetic powder may contain one metal element or a plurality of metal elements. The metal element contained in the magnetic powder may be, for example, any of base metal elements, noble metal elements, transition metal elements, and rare earth elements. The metal element contained in the magnetic powder may be, for example, at least one selected from the group consisting of iron (Fe), copper (Cu), titanium (Ti), manganese (Mn), cobalt (Co), nickel (Ni), zinc (Zn), aluminum (Al), tin (Sn), chromium (Cr), barium (Ba), strontium (Sr), lead (Pb), silver (Ag), praseodymium (Pr), neodymium (Nd), samarium (Sm), and dysprosium (Dy). The magnetic powder may contain elements other than metal elements. The magnetic powder may contain, for example, oxygen, boron, or silicon.

As the magnetic powder, at least one type of a composition selected from the group consisting of Fe-Si alloy, Fe-Si-Al alloy (Sendust), Fe-Ni alloy (Permalloy), Fe-Cu-Ni alloy (Permalloy), Fe-Cr-Si alloy, Fe-Cr alloy, Fe-Ni-Cr alloy (electromagnetic stainless steel), Nd-Fe-B alloy (rare earth magnet), Al-Ni-Co alloy (alnico magnet), and ferrite can be used. The ferrite may be, for example, spinel ferrite, hexagonal ferrite, or garnet ferrite.

The Fe-based alloy may be an Fe amorphous alloy. An Fe amorphous alloy powder is an amorphous powder obtained by quenching an alloy prepared by melting Fe as a main component together with other elements such as Si at a high temperature, and is also known as metallic glass. The Fe amorphous alloy powder can be produced according to any methods well known in the art. As the Fe amorphous alloy powder, it is possible to use commercially available products such as product names "AW2-08" and "KUAMET-6B2 available from Epson Atomix Corporation, product names "DAPMS3", "DAPMS7", "DAPMSA10", "DAPPB", "DAPPC", "DAPMKV49", "DAP410L", "DAP430L", and "DAPHYB series" available from Daido Steel Co., Ltd., and product names "MH45D", "MH28D", "MH25D", and "MH20D" available from Kobe Steel Co., Ltd.

The magnetic powder may contain one of the above elements and compositions, and may contain a plurality of types from among the above elements and compositions.

The magnetic powder may have a spherical shape, a substantially spherical shape, a flake shape, or an elliptical shape. The magnetic powder may also have various other shapes that have corners at a part. From the viewpoint of excellent fluidity, the magnetic powder may have a spherical shape.

The average particle diameter of the magnetic powder may be 0.005 to 50 µm. The term "average particle diameter" as used herein means a particle diameter at a cumulative value of 50% (volume base) in the particle size distribution. The magnetic powder may be a mixture of particles having two or three types of average particle diameters so as to be most closely packed.

The magnetic powder may have a coating on its surface. The coating may be formed from, for example, an inorganic salt, an acrylic resin, a silicic acid compound, or the like. The whole or a part of the surface of the magnetic powder may be coated with a surface treatment agent. The surface treatment agent may be, for example, an inorganic surface treatment agent such as an inorganic oxide, a phosphoric acid compound and a phosphate compound, a silane coupling agent, and the like, an organic surface treatment agent such as a montan wax and the like, and a resin cured product. A coupling agent described later may also be used as the surface treatment agent. For example, the whole or a part of the surface of the metallic magnetic powder such as an Fe-based alloy may be coated with an insulating material. Examples of the insulating material include silica, titania, calcium phosphate, montan wax, and cured epoxy resin.

The magnetic powder may include a magnetic powder whose surface is coated with an insulating material (hereinafter referred to as insulation-coated magnetic powder). One type of an insulation-coated magnetic powder may be used alone or two or more types may be used in combination. The average particle diameters of the two or more types of insulation-coated magnetic powders may be the same as or different from each other. The insulation-coated magnetic powder may be used together with a magnetic powder having no insulation coating (hereinafter referred to as uncoated magnetic powder). The average particle diameter of the uncoated magnetic powder may be the same as or different from the average particle diameter of the insulation-coated magnetic powder. For example, from the viewpoint of developing insulating properties, the average particle diameter of the uncoated magnetic powder may be smaller than the average particle diameter of the insulation-coated magnetic powder.

The insulation-coated magnetic powder may be an Fe amorphous alloy powder having an insulation coating. As such an insulation-coated magnetic powder, commercially available products such as "KUAMET9A4" (Fe-Si-B alloy, D50: 20 µm, with insulation coating) available from Epson Atomix Corporation and "SAP-2D(C)" (Fe-Si-B-PNb-Cr alloy, D50: 2.3 µm, with insulation coating) available from Sintokogio, Ltd. can be used. As the uncoated magnetic powder, commercially available products such as "SAP-2D" (Fe-Si-B-PNb-Cr alloy, D50: 2.3 µm, no insulation coating) available from Sintokogio, Ltd. and a soft ferrite powder "BSN-125" (Ni-Zn alloy, D50: 10 µm, no insulation coating) available from Toda Kogyo Corp. can be used.

The content of the magnetic powder in the composition for forming the insulating magnetic layer may be 70 parts by mass to 99 parts by mass or 80 parts by mass to 90 parts by mass when the total mass of the composition is 100 parts by mass.

As the binder resin varnish, a resin composition can be used.

The resin composition can contain an epoxy resin.

Examples of the epoxy resin include an epoxy resin having a condensed ring structure such as a naphthalene-type epoxy resin, a naphthalene-type tetrafunctional epoxy resin, a naphthol-type epoxy resin, a naphthylene ether-type epoxy resin, an anthracene-type epoxy resin, a dicyclopentadiene-type epoxy resin, a naphthalene-type epoxy resin, a naphthalene-type tetrafunctional epoxy resin, a naphthol-type epoxy resin, a naphthylene ether-type epoxy resin, a dicyclopentadiene-type epoxy resin, and the like; bisphenol A type epoxy resin; bisphenol F type epoxy resin; bisphenol S type epoxy resin; bisphenol AF type epoxy resin; tris-phenol type epoxy resin; novolac type epoxy resin; naphthol novolac type epoxy resin; phenol novolac type epoxy resin; tert-butyl-catechol type epoxy resin; glycidylamine type epoxy resin; glycidyl ester type epoxy resin; cresol novolac type epoxy resin; biphenyl type epoxy resin; linear aliphatic epoxy resin; epoxy resin having a butadiene structure; alicyclic epoxy resin; heterocyclic epoxy resin; epoxy resin containing a spiro ring; cyclohexanedimethanol type epoxy resin; trimethylol type epoxy resin; tetraphenylethane type epoxy resin; bixylenol type epoxy resin; and the like. One of these resins can be used alone, or two or more of these resins can be used in combination.

The epoxy resin may be an epoxy resin having two or more epoxy groups in one molecule. The epoxy resin may be liquid or solid at a temperature of 25°C.

As the epoxy resin that is liquid at 25°C (hereinafter, also referred to as "liquid epoxy resin"), it is possible to use a bisphenol A type epoxy resin, a bisphenol F type epoxy resin, a bisphenol AF type epoxy resin, a naphthalene type epoxy resin, a glycidyl ester type epoxy resin, a glycidyl amine type epoxy resin, a phenol novolac type epoxy resin, an alicyclic epoxy resin having an ester skeleton, a cyclohexane dimethanol type epoxy resin, a glycidyl amine type epoxy resin, and an epoxy resin having a butadiene structure. As the liquid epoxy resin, it is possible to use commercially available products such as "HP4032", "HP4032D", and "HP4032SS" (naphthalene-type epoxy resins) available from DIC Corporation, "828US" and "jER828EL" (bisphenol A type epoxy resins), "jER807" (bisphenol F type epoxy resin), "jER152" (phenol novolac type epoxy resin), "630" and "630LSD" (glycidyl amine type epoxy resins) available from Mitsubishi Chemical Group Corporation, "ZX1059" (a mixture of bisphenol A type epoxy resin and bisphenol F type epoxy resin) available from Shin-Nittetsu Sumikin Chemical Co., Ltd., "EX-721" (glycidyl ester type epoxy resin) available from Nagase ChemteX Corporation, "Celloxide 2021P" (alicyclic epoxy resin having an ester skeleton) and "PB-3600" (epoxy resin having a butadiene structure) available from Daicel Corporation, "ZX1658" and "ZX1658GS" (liquid 1,4-glycidylcyclohexane) available from Shin-Nittetsu Sumikin Chemical Co., Ltd., "630LSD" (glycidyl amine type epoxy resin) available from Mitsubishi Chemical Group Corporation, and "EP-3980S" (glycidyl amine type epoxy resin) available from ADEKA Corporation.

As the solid epoxy resin at 25°C, it is possible to use a naphthalene type tetrafunctional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, and a tetraphenylethane type epoxy resin. As the solid epoxy resin, it is possible to use commercially available products such as "HP4032H" (naphthalene type epoxy resin), "HP-4700" and "HP-4710" (naphthalene type tetrafunctional epoxy resins), "N-690" (cresol novolac type epoxy resin), "N-695" and "N-680" (cresol novolac type epoxy resins), "HP-7200" (dicyclopentadiene type epoxy resin), and "HP-7200HH", "HP-7200H", "EXA-7311", "EXA-7311-G3", "EXA-7311-G4", "EXA-7311-G4S", and "HP6000" (naphthylene ether type epoxy resins) available from DIC Corporation, "EPPN-502H" (trisphenol type epoxy resin), "NC-7000L" (naphthol novolac type epoxy resin), and "NC3000H", "NC3000", "NC3000L", and "NC3100" (biphenyl type epoxy resins) available from Nippon Kayaku Co., Ltd., "ESN475V" (naphthalene type epoxy resin) and "ESN485" (naphthol novolac type epoxy resin) available from Shin-Nittetsu Sumikin Chemical Co., Ltd., "YX4000H" and "YL6121" (biphenyl type epoxy resins), "YX4000HK" (bixylenol type epoxy resin), and "YX8800" (anthracene type epoxy resin) available from Mitsubishi Chemical Group Corporation, "PG-100" and "CG-500" available from Osaka Gas Chemicals Co., Ltd., "YL7760" (bisphenol AF type epoxy resin) and "YL7800" (fluorene type epoxy resin) available from Mitsubishi Chemical Group Corporation), and "jER1010" (solid bisphenol A type epoxy resin), "jER1031S" (tetraphenylethane-type epoxy resin), and "157S70" (novolac type epoxy resin) available from Mitsubishi Chemical Group Corporation.

The resin composition may contain a curing agent. Examples of the curing agent include a phenolic curing agent, a naphthol curing agent, a benzoxazine curing agent, and a cyanate ester curing agent. One curing agent may be used alone or two or more curing agents may be used in combination.

As the phenolic curing agent and the naphthol curing agent, a phenolic curing agent having a novolac structure, a naphthol curing agent having a novolac structure, a nitrogen-containing phenolic curing agent, and a triazine skeleton-containing phenolic curing agent may be used.

As the phenolic curing agents and naphthol curing agents, it is possible to use commercially available products such as "MEH-7700", "MEH-7810", and "MEH-7851" available from Meiwa Kasei Ltd., "NHN", "CBN", and "GPH" available from Nippon Kayaku Co., Ltd., "SN170", "SN180", "SN190", "SN475", "SN485", "SN495V", "SN375", and "SN395" available from Shin-Nittetsu Sumikin Chemical Co., Ltd., "TD2090", "TD2090-60M", "LA-7052", "LA-7054", "LA-1356", "LA-3018", "LA-3018-50P", "EXB-9500", "HPC-9500", "KA-1160", "KA-1163", and "KA-1165" available from DIC Corporation, and "GDP-6115L", "GDP-6115H", and "ELPC75" available from Gun Ei Chemical Industry Co., Ltd.

As the benzoxazine curing agent, it is possible to use commercially available products such as "HFB2006M" available from Showa Highpolymer Co., Ltd., and "P-d" and "F-a" available from Shikoku Chemicals Corporation.

Examples of the cyanate ester curing agent include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidenediphenyldicyanate, hexafluorobisphenol A dicyanate, 2,2-bis (4-cyanate) phenylpropane, 1,1-bis(4-cyanatephenylmethane), bis(4-cyanate-3,5-dimethylphenyl)methane, 1,3-bis(4-cyanatephenyl-1-(methylethylidene)) benzene, bis(4-cyanatephenyl) thioether, and bis(4-cyanatephenyl) ether, polyfunctional cyanate resins derived from phenol novolac, cresol novolac, and the like, and prepolymers resulting from such a cyanate resin being partially triazinated.

As the cyanate ester curing agent, it is possible to use commercially available products such as "PT30" and "PT60" (both phenol novolac type polyfunctional cyanate ester resins), "BA230" and "BA230S75" (prepolymers resulting from part or all of bisphenol A dicyanate being triazinated, to form trimers) available from Lonza Japan Ltd.

The content of the curing agent in the resin composition may be 0.1 parts by mass or greater, 0.3 parts by mass or greater, or 0.5 parts by mass or greater, and may be 5 parts by mass or less, 3 parts by mass or less, or 2 parts by mass or less, when the resin component in the resin composition is 100 parts by mass.

The resin composition may contain a curing accelerator. Examples of the curing accelerator include phosphorus-based curing accelerators, amine-based curing accelerators, imidazole-based curing accelerators, guanidine-based curing accelerators and metal-based curing accelerators, and phosphorus-based curing accelerators, amine-based curing accelerators, imidazole-based curing accelerators and metal-based curing accelerators. As the curing accelerator, one type can be used alone or two or more types can be used in combination.

Examples of the phosphorus-based curing accelerator include triphenylphosphine, phosphonium borate compounds, tetraphenylphosphonium tetraphenylborate, n-butylphosphonium tetraphenylborate, tetrabutylphosphonium decanoate, (4-methylphenyl) triphenylphosphonium thiocyanate, tetraphenylphosphonium thiocyanate, butyltriphenylphosphonium thiocyanate, and the like.

Examples of the amine-based curing accelerator include trialkylamines such as triethylamine and tributylamine, 4-dimethylaminopyridine, benzyldimethylamine, 2,4,6-tris (dimethylaminomethyl) phenol, 1,8-diazabicyclo(5,4,0)-undecene, and the like, and 4-dimethylaminopyridine, 1,8-diazabicyclo(5,4,0)-undecene, and the like.

Examples of the imidazole-based curing accelerator include imidazole compounds such as 2-methylimidazole, 2-undecylimidazole, 2-heptadecylimidazole, 1,2-dimethylimidazole, 2-ethyl-4 methylimidazole, 1,2-dimethylimidazole, 2-ethyl-4-methylimidazole, 2-phenylimidazole, 2-phenyl-4 methylimidazole, 1-benzyl-2 methylimidazole, 1-benzyl-2 phenylimidazole, 1-cyanoethyl-2 methylimidazole, 1-cyanoethyl-2 undecylimidazole, 1-cyanoethyl-2-ethyl-4 methylimidazole, 1-cyanoethyl-2 phenylimidazole, 1-cyanoethyl-2 undecylimidazolium trimellitite, 1-cyanoethyl-2-phenylimidazolium trimellitite, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2 phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a] benzimidazole, 1-dodecyl-2-methyl-3-benzylimidazolium chloride, 2-methylimidazoline, 2-phenylimidazoline, and the like, and adduct of an imidazole compound and epoxy resin.

As the imidazole-based curing accelerator, commercially available products such as "P200-H50" available from Mitsubishi Chemical Group Corporation can be used.

Examples of the guanidine-based curing accelerator include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]deca-5-ene, 7 methyl-1,5,7-triazabicyclo[4.4.0]deca-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, 1-(o-tolyl) biguanide, and the like.

Examples of the metal-based curing accelerator include organometallic complexes or organometallic salts of metals such as cobalt, copper, zinc, iron, nickel, manganese, tin, and the like. Examples of the organometallic complexes include organocobalt complexes such as cobalt (II) acetylacetonate, cobalt (III) acetylacetonate, and the like, organocopper complexes such as copper (II) acetylacetonate and the like, organozinc complexes such as zinc (II) acetylacetonate and the like, organoiron complexes such as iron (III) acetylacetonate and the like, organonickel complexes such as nickel (II) acetylacetonate and the like, and organomanganese complexes such as manganese (II) acetylacetonate, and the like. Examples of the organometallic salts include zinc octylate, tin octylate, zinc naphthenate, cobalt naphthenate, tin stearate, zinc stearate, and the like.

The content of the curing accelerator in the resin composition may be 0.001 parts by mass or greater, 0.005 parts by mass or greater, or 0.01 parts by mass or greater, and 0.1 parts by mass or less, 0.08 parts by mass or less, or 0.05 parts by mass or less, when the nonvolatile component in the resin composition is 100 parts by mass.

The resin composition may contain a thermoplastic resin. Examples of the thermoplastic resin include phenoxy resins, polyvinyl acetal resins, polyolefin resins, polybutadiene resins, siloxane resins, poly(meth)acrylic resins, polyalkylene resins, polyalkyleneoxy resins, polyisoprene resins, polyisobutylene resins, polyimide resins, polyamideimide resins, polyetherimide resins, polysulfone resins, polyethersulfone resins, polyphenylene ether resins, polycarbonate resins, polyetheretherketone resins, and polyester resins.

As the phenoxy resins, it is possible to use commercially available products such as "1256" and "4250" (both phenoxy resins containing a bisphenol A structure), "YX8100" (phenoxy resin containing a bisphenol S skeleton), and "YX6954" (phenoxy resin containing a bisphenol acetophenone structure) available from Mitsubishi Chemical Group Corporation, and "FX280" and "FX293" available from Shin-Nittetsu Sumikin Chemical Co., Ltd., "YX7180", "YX6954", "YX7553", "YX7553BH30", "YL7553BH30", "YL7769", "YL6794", "YL7213", "YL7290", "YL7891", and "YL7482" available from Mitsubishi Chemical Group Corporation.

The thermoplastic resin may have one or more types of structures selected from a polybutadiene structure, a polysiloxane structure, a poly(meth)acrylate structure, a polyalkylene structure, a polyalkyleneoxy structure, a polyisoprene structure, a polyisobutylene structure, and a polycarbonate structure in the molecule. These structures may be contained in the main chain or a side chain. The polybutadiene structure may be partially or entirely hydrogenated. The polyalkyleneoxy structure may be a polyalkyleneoxy structure having 2 to 15 carbon atoms, a polyalkyleneoxy structure having 3 to 10 carbon atoms, or a polyalkyleneoxy structure having 5 or 6 carbon atoms.

The thermoplastic resin may have a number average molecular weight (Mn) of 1,000 or greater, 1,500 or greater, 3,000 or greater, or 5,000 or greater, and 1,000,000 or less, or 900,000 or less. The number average molecular weight (Mn) means a number average molecular weight in terms of polystyrene measured by Gel Permeation Chromatography (GPC).

The thermoplastic resin may have a functional group capable of reacting with epoxy resin. The functional group capable of reacting with epoxy resin may be one or more functional groups selected from the group consisting of a hydroxy group, a carboxy group, an acid anhydride group, a phenolic hydroxyl group, an epoxy group, an isocyanate group, and a urethane group.

As the polybutadiene resin, it is possible to use commercially available products such as "Ricon 130MA8", "Ricon 130MA13", "Ricon 130MA20", "Ricon 131MA5", "Ricon 131MA10", "Ricon 131MA17", "Ricon 131MA20", and "Ricon 184MA6" (polybutadiene containing an acid anhydride group) available from Cray Valley S.A., "GQ-1000" (hydroxyl group and carboxyl group-incorporated polybutadiene), "G-1000", "G-2000", and "G-3000" (polybutadiene having hydroxyl groups at both ends), and "GI-1000", "GI-2000", and "GI-3000" (hydrogenated polybutadiene hydrogenated having hydroxyl groups at both ends) available from Nippon Soda Co., Ltd., "FCA-061L" (hydrogenated polybutadiene skeleton epoxy resin) available from Nagase ChemteX Corporation, and the like.

As the poly(meth)acrylic resin, commercially available products such as Teisan resin available from Nagase ChemteX Corporation, "ME-2000", "W-116.3", "W-197C", "KG-25", and "KG-3000" available from Negami Chemical Industrial Co., Ltd., and the like can be used.

As the polycarbonate resin, commercially available products such as "T6002" and "T6001" (polycarbonate diol) available from Asahi Kasei Corporation, "C-1090", "C-2090", and "C-3090" (polycarbonate diol) available from Kuraray Co., Ltd., and the like can be used.

As the thermoplastic resins, it is possible to use commercially available products such as "SMP-2006", "SMP-2003PGMEA", and "SMP-5005PGMEA" available from Shin-Etsu Silicone, linear polyimides made from amine group-terminated polysiloxanes and tetrabasic acid anhydrides (International Publication No. WO 2010/053185, Japanese Patent Application Laid-Open Publication No. 2002-12667, and Japanese Patent Application Laid-Open Publication No. 2000-319386, and the like), "PTXG-1000" and "PTXG-1800" available from Asahi Kasei Fibers Corporation, "KL-610" and "KL613" available from Kuraray Co., Ltd., "SIBSTAR-073T" (styrene-isobutylene-styrene triblock copolymer) and "SIBSTAR-042D" (styrene-isobutylene diblock copolymer) available from Kaneka Corporation, "Denka butyral 4000-2", "Denka butyral 5000-A", "Denka butyral 6000-C", and "Denka butyral 6000-EP" available from Denka Company Limited, S-LEC BH series, BX series (for example, BX-5Z), KS series (for example, KS-1), BL series, and BM series available from Sekisui Chemical Co., Ltd., "Ricacoat SN20" and "Ricacoat PN20" available from New Japan Chemical Co., Ltd., "Viromax HR11NN" and "Viromax HR16NN" available from Toyobo Co., Ltd., "KS9100" and "KS9300" available from Hitachi Chemical Company, Ltd., "PES25003P" available from Sumitomo Chemical Company, Limited, polysulfones "P1700" and "P3500" available from Solvay Advanced Polymer Co., Ltd., "AC3832" available from Ganz Chemical Co., Ltd., and the like.

The content of the thermoplastic resin in the resin composition may be 0.1 parts by mass or greater, 0.3 parts by mass or greater, or 0.5 parts by mass or greater, and 20 parts by mass or less, 10 parts by mass or less, 5 parts by mass or less, or 3 parts by mass or less when the nonvolatile component in the resin composition is 100 parts by mass.

The resin composition can contain an active ester compound having one or more active ester groups in one molecule. One active ester compound may be used alone, or two or more may be used in combination.

As the active ester compound, a compound having two or more ester groups having high reaction activity in one molecule, such as phenol esters, thiophenol esters, N-hydroxyamine esters, and esters of heterocyclic hydroxy compounds can be used. Examples of such active ester compounds include those obtained by a condensation reaction of a carboxylic acid compound and/or a thiocarboxylic acid compound with a hydroxy compound and/or a thiol compound.

From the viewpoint of improving heat resistance, the active ester compound may be an active ester compound obtained from a carboxylic acid compound and a hydroxy compound, or an active ester compound obtained from a carboxylic acid compound and a phenol compound and/or a naphthol compound. Examples of the carboxylic acid compound include benzoic acid, acetic acid, succinic acid, maleic acid, itaconic acid, phthalic acid, isophthalic acid, terephthalic acid, pyromellitic acid, and the like. Examples of the phenol compound or the naphthol compound include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, dicyclopentadiene-type diphenol compound, phenol novolac, and the like. Here, the "dicyclopentadiene-type diphenol compound" refers to a diphenol compound obtained by condensing one dicyclopentadiene molecule with two phenol molecules.

Specific examples of the active ester compound include an active ester compound containing a dicyclopentadiene-type diphenol structure, an active ester compound containing a naphthalene structure, an active ester compound containing an acetylated product of phenol novolac, and an active ester compound containing a benzoylated product of phenol novolac. The "dicyclopentadiene-type diphenol structure" represents a divalent structural unit consisting of phenylene-dicyclopentylene-phenylene.

It is possible to use commercially available products such as "EXB9451", "EXB9460", "EXB9460S", "HPC-8000-65T", "HPC-8000H-65TM", "EXB-8000L-65TM", and "EXB-8150-65T" (available from DIC Corporation) as active ester compounds containing a dicyclopentadiene-type diphenol structure, "EXB9416-70BK" (available from DIC Corporation) as an active ester compound containing a naphthalene structure, "DC808" (available from Mitsubishi Chemical Group Corporation) as an active ester compound containing an acetylated product of phenol novolac, "YLH1026" (available from Mitsubishi Chemical Group Corporation) as an active ester compound containing a benzoylated product of phenol novolac, "DC808" (available from Mitsubishi Chemical Group Corporation) as an active ester compound as an acetylated product of phenol novolac, "YLH1026" (available from Mitsubishi Chemical Group Corporation) as an active ester-based curing agent as a benzoylated product of phenol novolac, "YLH1030" (available from Mitsubishi Chemical Group Corporation), "YLH1048" (available from Mitsubishi Chemical Group Corporation), and the like.

When the resin composition contains an active ester compound and an epoxy resin, the amount ratio between the epoxy resin and the active ester compound, expressed as a ratio of [total number of epoxy groups in the epoxy resin] : [total number of active ester groups in the active ester compound] may be 1:0.01 to 1:5, 1:0.05 to 1:3, or 1:0.1 to 1:1.5.

The content of the active ester compound in the resin composition may be 1 part by mass or greater, 1.5 parts by mass or greater, or 2 parts by mass or greater, and may be 40 parts by mass or less, 30 parts by mass or less, 20 parts by mass or less, 10 parts by mass or less, 8 parts by mass or less, or 5 parts by mass or less when the nonvolatile component in the resin composition is 100 parts by mass.

The resin composition can contain a carbodiimide compound having one or more carbodiimide groups (-N=C=N-) in one molecule. As the carbodiimide compound, a compound having two or more carbodiimide groups in one molecule may be used. One carbodiimide compound may be used alone, or two or more carbodiimide compounds may be used in combination.

Examples of the carbodiimide compound include compounds containing a structure represented by formula (A) below.

-(X)ₚ-N=C=N- ---(A)

[In the formula, X represents an alkylene group, a cycloalkylene group, or an arylene group, which may have a substituent. p represents an integer of 1 to 5. When there are more than one X, they may be the same or different.]

The number of carbon atoms in the alkylene group represented by X (excluding the number of carbon atoms in the substituent) may be 1 to 20, 1 to 10, 1 to 6, 1 to 4, or 1 to 3. Examples of the alkylene group include a methylene group, an ethylene group, a propylene group, and a butylene group.

The number of carbon atoms in the cycloalkylene group represented by X (excluding the number of carbon atoms in the substituent) may be 3 to 20, 3 to 12, or 3 to 6. Examples of the cycloalkylene group include a cyclopropylene group, a cyclobutylene group, a cyclopentylene group, and a cyclohexylene group.

The arylene group represented by X is a group obtained by removing two hydrogen atoms on an aromatic ring from aromatic hydrocarbon. The number of carbon atoms in the arylene group (excluding the number of carbon atoms in the substituent) may be 6 to 24, 6 to 18, 6 to 14, or 6 to 10. Examples of the arylene group include a phenylene group, a naphthylene group, and an anthracenylene group.

An alkylene group, a cycloalkylene group, or an aryl group represented by X may have a substituent. Examples of the substituent include a halogen atom, an alkyl group, an alkoxy group, a cycloalkyl group, a cycloalkyloxy group, an aryl group, an aryloxy group, an acyl group, and an acyloxy group. Examples of the halogen atom used as the substituent include a fluorine atom, a chlorine atom, a bromine atom, and an iodine atom. The alkyl group or the alkoxy group as the substituent may be either linear or branched, and the number of carbon atoms thereof may be 1 to 20, 1 to 10, 1 to 6, 1 to 4, or 1 to 3. The number of carbon atoms in the cycloalkyl group or the cycloalkyloxy group as the substituent may be 3 to 20, 3 to 12, or 3 to 6. The aryl group as the substituent is a group obtained by removing one hydrogen atom on an aromatic ring from aromatic hydrocarbon, and the number of carbon atoms thereof may be 6 to 24, 6 to 18, 6 to 14, or 6 to 10. The number of carbon atoms in the aryloxy group as the substituent may be 6 to 24, 6 to 18, 6 to 14, or 6 to 10. The acyl group as the substituent is a group represented by a formula -C(=O)-R¹ (in the formula, R¹ represents an alkyl group or an aryl group). The alkyl group represented by R¹ may be either linear or branched, and the number of carbon atoms thereof may be 1 to 20, 1 to 10, 1 to 6, 1 to 4, or 1 to 3. The number of carbon atoms in the aryl group represented by R¹ may be 6 to 24, 6 to 18, 6 to 14, or 6 to 10. The acyloxy group as the substituent is a group represented by a formula: -O-C(=O)-R² (in the formula, R² represents an alkyl group or an aryl group).

In the formula (A), p represents an integer of 1 to 5. p may be 1 to 4, 2 to 4, 2, or 3.

The content of the structure represented by the formula (A) in the carbodiimide compound may be 50 parts by mass or greater, 60 parts by mass or greater, 70 parts by mass or greater, 80 parts by mass or greater, or 90 parts by mass or greater when the mass of the entire carbodiimide compound molecule is 100 parts by mass. The carbodiimide compound may be substantially composed of the structure represented by the formula (A) except for the terminal structure. Examples of the terminal structure of the carbodiimide compound include an alkyl group, a cycloalkyl group, and an aryl group, which may have a substituent. The alkyl group, the cycloalkyl group, and the aryl group used as the terminal structure may be the same as the alkyl group, the cycloalkyl group, and the aryl group described regarding the substituent that may be contained in the group represented by X. Further, the substituent that may be contained in the group used as the terminal structure may be the same as the substituent that may be contained in the group represented by X.

The weight average molecular weight of the carbodiimide compound may be 500 or greater, 600 or greater, 700 or greater, 800 or greater, 900 or greater, or 1,000 or greater, and may be 5,000 or less, 4,500 or less, 4,000 or less, 3,500 or less, or 3,000 or less. The weight average molecular weight of the carbodiimide compound can be measured, for example, by the gel permeation chromatography (GPC) method (in terms of polystyrene).

When the carbodiimide compound contains an isocyanate group (-N=C=O) in the molecule, the content of the isocyanate group (also referred to as "NCO content") in the carbodiimide compound may be 5% by mass or less, 4% by mass or less, 3% by mass or less, 2% by mass or less, 1% by mass or less, or 0.5% by mass or less.

As the carbodiimide compound, commercially available products such as Carbodilite (registered trademark) V-02B, V-03, V-04K, V-07, and V-09 available from Nisshinbo Chemical Inc., Stabaxol (registered trademark) P and P400, and Haikazil 510 available from Rhein Chemie Rheinau GmbH may be used.

The content of the carbodiimide compound in the resin composition may be 0.1 parts by mass or greater, 0.3 parts by mass or greater, or 0.5 parts by mass or greater, and may be 3 parts by mass or less, 2 parts by mass or less, or 1.5 parts by mass or less when the nonvolatile component in the resin composition is 100 parts by mass.

The resin composition may further contain other additives if necessary. Examples of the other additives include resin additives such as flame retardants, organometallic compounds such as organocopper compounds, organozinc compounds, organocobalt compounds, and the like, binders, thickening agents, defoaming agents, leveling agents, close adhesiveness-imparting agents, colorants, and the like.

The composition for forming the insulating magnetic layer may be in the form of a paste (hereinafter referred to as "paste"). The paste may contain a magnetic powder, an epoxy group-containing compound, and a curing agent.

The magnetic powder described above may be used as the magnetic powder.

The average particle diameter of the magnetic powder contained in the paste may be 0.05 to 200 µm, 0.5 to 100 µm, or 1 to 50 µm. When the magnetic powder is coated, the average particle diameter of the magnetic powder including the coating film may be within the above range.

The content of the magnetic powder in the paste may be 70% by mass or greater, or 80% by mass or greater, and may be 99% by mass or less, or 90% by mass or less relative to the total mass of the paste. The content of the magnetic powder in the paste may be 70% to 99% by mass or 80% to 90% by mass relative to the total mass of the paste.

The epoxy group-containing compound means a compound having one or more epoxy groups in the molecule, and may be in the form of a monomer, or an oligomer or a polymer including a structural unit formed by polymerization of the monomer. The epoxy group-containing compound can function as a binder resin that cures by heat treatment for binding metallic element-containing powder particles. Examples of the epoxy group-containing compound include oligomers and polymers having two or more epoxy groups in the molecule, commonly known as epoxy resins. Other examples of the epoxy group-containing compound include compounds having one or more epoxy groups in the molecule but free of a structural unit formed by polymerization (hereinafter referred to as epoxy compounds). Such epoxy compounds are generally known as reactive diluents. It is preferable that the epoxy group-containing compound contains at least one type selected from the group consisting of epoxy resins and epoxy compounds.

As the epoxy resin, the same as that that is blended in the above-described resin composition may be used.

The molecular weight of the epoxy compound may be 100 or greater, 150 or greater, or 200 or greater. When using an epoxy compound having a molecular weight of 100 or greater, it is possible to inhibit volatilization thereof before reacting with the curing agent by setting appropriate curing conditions. In addition, an epoxy compound having a low molecular weight has a short inter-crosslinking-point distance after reaction and its cured product can avoid occurrence of trouble of being ready to crack. On the other hand, the molecular weight of the epoxy compound may be 700 or less, 500 or less, or 300 or less. When using an epoxy compound having a molecular weight of 700 or less, an appropriate viscosity as a diluent can be easily obtained.

The molecular weight of the epoxy compound may be 100 to 700, 150 to 500, or 200 to 300. When using an epoxy compound having a molecular weight in this range, it is easy to adjust the viscosity of the paste. Unlike components such as organic solvents that volatilize during heating, the epoxy compound cures during heating and is incorporated into the cured product. Therefore, when an epoxy compound is used, it contributes to the viscosity adjustment of the paste, and, on the other hand, can inhibit deterioration of the cured product properties.

The epoxy compound may contain one, or two or more epoxy groups in the molecule. The epoxy compound may be, for example, at least one selected from the group consisting of n-butyl glycidyl ether, versatic acid glycidyl ether, styrene oxide, ethylhexyl glycidyl ether, phenyl glycidyl ether, butyl phenyl glycidyl ether, 1,6-hexanediol diglycidyl ether, neopentyl glycol diglycidyl ether, diethylene glycol diglycidyl ether, and trimethylolpropane triglycidyl ether. The epoxy compound may contain 500 ppm or less of ionic impurities such as free Na ions and free Cl ions.

The epoxy equivalent of the epoxy group-containing compound may be 80 g/eq to 350 g/eq, 100 g/eq to 300 g/eq, or 120 g/eq to 250 g/eq. When the epoxy equivalent is within the above range, the viscosity of the epoxy group-containing compound itself becomes low, so that the viscosity of the paste can be easily adjusted.

It is preferable that the epoxy group-containing compound includes an epoxy group-containing compound that is liquid at 25°C. The term "liquid at 25°C" as used herein means that the viscosity of the epoxy group-containing compound at 25°C is 200 Pa·s or lower. The above viscosity is a value measured using an E-type viscometer under the following conditions: temperature: 25°C, cone plate type: SPP, cone angle: 1°34', and rotation rate: 2.5 rpm. As the E-type viscometer, for example, a TV-33 type viscometer available from Toki Sangyo Co., Ltd. can be used.

When an epoxy group-containing compound that is liquid at 25°C is used, the blending amount of volatile components, such as an organic solvent, routinely used to obtain fluidity, can be greatly reduced. In one embodiment, a paste containing no organic solvent can be formed. In addition, it is possible to increase the content of the magnetic powder easily while ensuring appropriate fluidity as a paste. From these points of view, the viscosity of the epoxy group-containing compound may be 100 Pa·s or lower, 50 Pa·s or lower, or 10 Pa·s or lower.

The viscosity of the epoxy compound, among the above epoxy group-containing compounds, may be lower than the viscosity of the liquid epoxy resin from the viewpoint of adjusting the paste viscosity. The viscosity of the epoxy compound may be 1 Pa·s or lower, 0.5 Pa·s or lower, or 0.1 Pa·s or lower.

The epoxy group-containing compound that is liquid at 25°C may include at least one type selected from the group consisting of an epoxy resin that is liquid at 25°C and an epoxy compound that is liquid at 25°C. The content of the epoxy resin that is liquid at 25°C may be 50% by mass or greater, 70% by mass or greater, 90% by mass or greater, or 100% by mass relative to the total mass of the epoxy group-containing compound.

The epoxy resin that is liquid at 25°C may include, for example, at least one type of a liquid epoxy resin selected from a bisphenol A type epoxy resin, a bisphenol F type epoxy resin, a bisphenol AD type epoxy resin, a bisphenol S type epoxy resin, a naphthalenediol type epoxy resin, a hydrogenated bisphenol A type epoxy resin, and an aminoglycidyl ether type epoxy resin.

Epoxy group-containing compounds that are liquid at 25°C can also be obtained commercially. For example, they are sold as liquid bisphenol A type epoxy resin and liquid bisphenol F type epoxy resin by Nippon Steel Chemical Co., Ltd. For example, product name "YDF-8170C" (having an epoxy equivalent weight of 165, and a viscosity of 1,000 to 1,500 mPa·s) can be used as the liquid bisphenol F type epoxy resin. Examples of the epoxy compounds include the series of Adeka glycylol (product name) available from ADEKA Corporation. For example, product name "Adeka glycylol ED-503G" (having an epoxy equivalent weight of 135, and a viscosity of 15 mPa·s) can be used.

The paste may further contain other resins in addition to the epoxy group-containing compounds. The other resins may contain at least one type selected from the group consisting of thermosetting resins (excluding epoxy resins) and thermoplastic resins. The thermosetting resin may be, for example, at least one type selected from the group consisting of phenolic resins, acrylic resins, polyimide resins, and polyamideimide resins. When a phenolic resin is used in addition to the epoxy group-containing compound, the phenolic resin can also function as the curing agent for the epoxy group-containing compound.

The thermoplastic resin may be, for example, at least one type selected from the group consisting of acrylic resin, polyethylene, polypropylene, polystyrene, polyvinyl chloride, and polyethylene terephthalate. The resin component may further include a silicone resin in addition to the epoxy group-containing compound.

When the paste contains a resin other than the epoxy group-containing compound, it is preferable to adjust the content of the other resin so as not to reduce the effect of the epoxy group-containing compound. For example, the content of the other resin may be 50% by mass or less, 30% by mass or less, or 10% by mass or less relative to the total mass of the resins in the paste. The blending amount can be adjusted so that the viscosity of the mixture of the epoxy group-containing compound and the other resin is 50 Pa·s or lower at 25°C. The viscosity is a value measured using an E-type viscometer under the following conditions: temperature: 25°C, cone plate type: SPP, cone angle: 1°34', and rotation rate: 2.5 rpm. As the E-type viscometer, for example, a TV-33 type viscometer available from Toki Sangyo Co., Ltd. can be used.

As the curing agent, a compound that can impart an appropriate viscosity to the paste and can react with the epoxy group of the epoxy group-containing compound to form a cured product can be used. As the curing agent, well-known curing agents generally used as curing agents for epoxy resins can be used. Examples of curing agents include phenolic curing agents, acid anhydride curing agents, and amine curing agents.

The curing agent is classified into a curing agent that cures the epoxy resin in a temperature range from low temperature to room temperature, and a heat curing-type curing agent that cures the epoxy resin with heating. Examples of curing agents that cure the epoxy resin in the temperature range from low temperature to room temperature include aliphatic polyamines, polyaminoamides, and polymercaptans. Examples of heat curing-type curing agents include aromatic polyamines, acid anhydrides, phenol novolac resins, and dicyandiamide (DICY). When a curing agent that cures the epoxy resin in the temperature range from low temperature to room temperature is used, the cured product of the epoxy resin tends to have a low glass transition point and be soft. As a result, the insulating magnetic layer formed from the paste tends to be soft as well. From the viewpoint of improving the heat resistance and the mechanical strength of the insulating magnetic layer, it is preferable that the curing agent includes a heat curing-type curing agent.

Among the heat curing-type curing agents, a curing agent that is liquid at 25°C can be used from the viewpoint of reducing the viscosity of the paste. As the liquid curing agent, for example, at least one type selected from the group consisting of aliphatic polyamines, polymercaptans, aromatic polyamines, acid anhydrides, and imidazole-based curing agents can be used. As long as it is possible to inhibit increase in the viscosity of the paste, a curing agent that is solid at 25°C may be used, and a liquid curing agent and a solid curing agent may be used in combination. As the solid curing agent, for example, dicyandiamide, tertiary amine, an imidazole-based curing agent, and an imidazoline-based curing agent can be used. Since the solid curing agents listed as examples are polyfunctional or act catalytically, they can sufficiently function even in a small amount.

The curing agent may contain at least one type selected from the group consisting of amine-based curing agents, imidazole-based curing agents, and imidazoline-based curing agents. The curing agent may contain at least an amine-based curing agent. Amine-based curing agents (more specifically, tertiary amines), imidazole-based curing agents, and imidazoline-based curing agents can also be used as curing accelerators in a combination with other curing agents.

The amine-based curing agent may be a compound having at least two amino groups in the molecule. The amine-based curing agent contains at least one type selected from the group consisting of aliphatic amines and aromatic amines. Examples of the aliphatic amine compounds include diethylenetriamine, triethylenetetramine, n-propylamine, 2-hydroxyethylaminobropylamine, cyclohexylamine, and 4,4'-diamino-dicyclohexylmethane. Examples of the aromatic amine compounds include 4,4'-diaminodiphenylmethane, 2-methylaniline, an amine compound represented by formula (1) below, and an amine compound represented by formula (2) below. 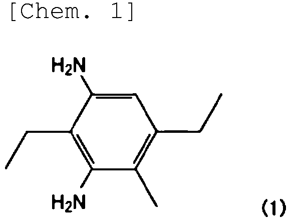 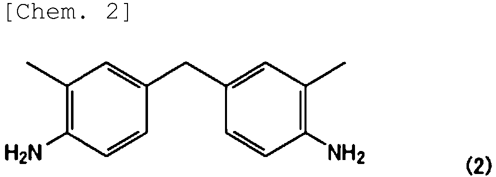 The imidazole-based curing agent is a compound having an imidazole skeleton, and may be an imidazole-based compound obtained by replacing a hydrogen atom in the molecule with a substituent. The imidazole-based curing agent may be a compound having an imidazole skeleton such as an alkyl group-substituted imidazole. Examples of the imidazole-based curing agent include imidazole, 2-methylimidazole, 2-ethylimidazole, and 2-isopropylimidazole. As the imidazole-based curing agent, a commercially available product such as "Cuazole 2E4MZ" (2-ethyl-4-methylimidazole) available from Shikoku Chemicals Corporation can be used.

The imidazoline-based curing agent is a compound having an imidazoline skeleton, and may be an imidazoline-based compound obtained by replacing a hydrogen atom in the molecule with a substituent. The imidazoline-based curing agent may be a compound having an imidazoline skeleton such as an alkyl group-substituted imidazoline. Examples of the imidazoline-based curing agent include imidazoline, 2-methylimidazoline, and 2-ethylimidazoline.

The curing agent may contain an aromatic amine from the viewpoint of adaptability with an epoxy resin that is liquid at 25°C and storage stability. The aromatic ring of the aromatic amine may have a substituent other than an amino group. For example, it may have an alkyl group having one to five carbon atoms or an alkyl group having one or three carbon atoms. The number of aromatic rings in the aromatic amine may be one, or two or greater. When the number of aromatic rings is two or greater, the aromatic rings may be bonded with each other by single bond or via a linking group such as an alkylene group.

From the viewpoint of the viscosity of the paste, it is preferable that the curing agent contains a liquid aromatic amine. For example, at least one type selected from the group consisting of a compound represented by the above formula (1) and a compound represented by the above formula (2) can be used.

The liquid aromatic amine usable as the curing agent can also be obtained commercially. For example, product name "Grade: jER Cure WA" available from Mitsubishi Chemical Group Corporation and product name "Kayahard AA" available from Nippon Kayaku Co., Ltd. can be cited.

The content of the curing agent in the paste can be set in consideration of the ratio between the number of epoxy group equivalents in the epoxy group-containing compound such as an epoxy resin or the like and the number of active group equivalents in the curing agent. For example, the ratio of the curing agent to one epoxy group equivalent in the epoxy group-containing compound may be 0.5 to 1.5 equivalents, 0.9 to 1.4 equivalents, or 1.0 to 1.2 equivalents.

When the ratio of the active group in the curing agent is 0.5 equivalents or greater, it is possible to restrict decrease in the curing rate of the epoxy resin due to reduction in the amount of OH per unit weight of the epoxy resin through heat curing. In addition, it is possible to restrict decrease in the glass transition temperature of the cured product to be obtained, and decrease in the elastic modulus of the cured product. Furthermore, it is possible to restrict deterioration of the insulation reliability of the cured product due to any unreacted resin component in the binder resin. On the other hand, when the ratio of the active groups in the curing agent is 1.5 equivalents or less, it is possible to restrict decrease in the mechanical strength of the insulating magnetic layer formed from the paste after heat curing. In addition, it is possible to restrict decrease in the insulating property of the cured product due to any unreacted curing agent.

The paste may optionally further contain a curing accelerator. The paste may contain a magnetic powder, an epoxy group-containing compound, a curing agent, and a curing accelerator. In another embodiment, the paste may further contain additives such as a coupling agent and a flame retardant in addition to the above components.

The curing accelerator is not limited as long as it is a compound capable of promoting a curing reaction between the epoxy resin and the curing agent. Examples of the curing accelerator include a tertiary amine, an imidazole-based curing accelerator, an imidazoline-based curing accelerator, and a phosphorus compound. As the imidazole-based curing accelerator and the imidazoline-based curing accelerator, the compounds listed as examples above as the imidazole-based curing agents and the imidazoline-based curing agents may be used. When using a liquid acid anhydride among the liquid curing agents, a curing accelerator may be used in combination. The paste may contain one or more types of curing accelerators. When a curing accelerator is used, the mechanical strength of the insulating magnetic layer formed from the paste can be improved and it is easy to lower the curing temperature of the paste.

The blending amount of the curing accelerator may be any amount that can provide a curing accelerating effect, and is not particularly limited. However, from the viewpoint of improving the curing property and fluidity if the paste has absorbed moisture, the amount of the curing accelerator may be 0.001 parts by mass or greater relative to the total 100 parts by mass of the epoxy resin and the curing agent. The blending amount of the curing accelerator may be 0.01 parts by mass or greater, or may be 0.1 parts by mass or greater. On the other hand, the blending amount of the curing accelerator may be 5 parts by mass or less, 4 parts by mass or less, or 3 parts by mass or less. When the blending amount of the curing accelerator is 0.001 parts by mass or greater, a sufficient curing promoting effect can be easily obtained. When the blending amount of the curing accelerator is 5 parts by mass or less, excellent storage stability of the paste can be easily obtained.

When a coupling agent is used, the dispersibility of the magnetic powder in the paste can be improved and it is easy to control the viscosity of the paste. Moreover, improvement of the close adhesiveness between the binder resin and the magnetic powder is facilitated. Furthermore, improvement of close adhesiveness of the insulating magnetic layer formed from the paste with the conductor wiring, and flexibility and mechanical strength of the insulating magnetic layer is facilitated. The coupling agent may be, for example, at least one type selected from the group consisting of silane-based compounds (silane coupling agents), titanium-based compounds, aluminum compounds (aluminum chelates) and aluminum/zirconium-based compounds. The silane coupling agent may be, for example, at least one type selected from the group consisting of epoxy silane, mercapto silane, amino silane, alkyl silane, ureido silane, acid anhydride silane, and vinyl silane. The silane coupling agent may be an amino phenyl-based silane coupling agent. The paste may contain at least one type of the above coupling agents, or may contain two or more types of the above coupling agents.

For environmental safety, recyclability, moldability and cost reduction of the paste, the paste may contain a flame retardant. The flame retardant may be, for example, at least one type selected from the group consisting of bromine-based flame retardants, phosphorus-based flame retardants, hydrated metal compound-based flame retardants, silicone-based flame retardants, nitrogen-containing compounds, hindered amine compounds, organometallic compounds, and aromatic engineering plastics. The paste may contain one type, or two or more types of the flame retardants listed as examples above.

The paste may optionally contain an organic solvent. The organic solvent is not particularly limited. For example, an organic solvent capable of dissolving a binder resin may be used. The organic solvent may be, for example, at least one type selected from the group consisting of acetone, methyl ethyl ketone, methyl isobutyl ketone, benzene, toluene, carbitol acetate, butyl carbitol acetate, cyclohexanone, and xylene. From the viewpoint of handleability, the organic solvent may be liquid at normal temperature (25°C). From the viewpoint of handleability, the boiling point of the organic solvent may be 50°C or higher and 160°C or lower.

When the paste contains an organic solvent, the content thereof may be 5% by mass or lower, 3% by mass or lower, or 1% by mass or lower relative to the total mass of the paste. The paste may be substantially free of an organic solvent. In this specification, "substantially free" means that no organic solvent is intentionally added to the paste. Therefore, the paste may contain, for example, an organic solvent that is used in the production of the resin and remains in the resin.

The viscosity of the paste may be 1 Pa·s or higher, 10 Pa·s or higher, or 100 Pa·s or higher. By adjusting the viscosity to 1 Pa·s or higher, liquid dripping after application of the paste can be inhibited, and prevention of collapse of the pattern shape after printing can be facilitated. In addition, sedimentation of the magnetic powder in the paste can be inhibited, and prevention of temporal deterioration of the coating property after the paste is stirred can be better facilitated. On the other hand, the viscosity of the paste may be 600 Pa·s or lower, 400 Pa·s or lower, or 200 Pa·s or lower. By adjusting the viscosity to 600 Pa·s or lower, which generates fluidity in the paste, it is easy to obtain a good coating property.

When the paste is applied to screen printing, the viscosity of the paste may be 10 Pa·s to 400 Pa·s, 50 Pa·s to 300 Pa·s, or 100 Pa·s to 250 Pa·s. When the viscosity is adjusted to the above range, the occurrence of a failure of the paste to permeate the openings of the plate in screen printing can be avoided. The viscosity of the paste can be freely adjusted based on the structure and properties of the epoxy group-containing compound, the structure and properties of the curing agent, and the combination and blending ratio thereof, and the structure and blending ratio of the additives such as the curing accelerator, the coupling agent, and the like. The paste may contain additives such as a viscosity modifier, a thixotropic agent, a dispersion stabilizer, and the like.

Although the embodiments have been described above, the above embodiments are presented as examples, and the present invention is not limited by the above embodiments. The above embodiments may be implemented in various other forms, and various combinations, omissions, substitutions, modifications, and the like are applicable without departing from the scope of the spirit of the invention. These embodiments and modifications thereof are included in the scope and spirit of the invention, as well as in the scope of the invention described in the claims and equivalents thereof.

This international application claims priority based on Japanese Patent Application No. 2023-104222 filed June 26, 2023, and the entire contents of Japanese Patent Application No. 2023-104222 are incorporated herein by reference.

### REFERENCE SIGNS LIST

- 10: wiring board
- 11: conductor wiring
- 12: substrate
- 13: lower surface
- 14: upper surface
- 15: input end
- 16: output end
- 20: insulating layer
- 21: first principal surface
- 22: second principal surface
- 30: magnetic layer
- 40: insulating layer
- 50: conductor layer
- 101, 102: wiring board

## Claims

1. A wiring board, comprising:
conductor wiring;
an insulating layer having a first principal surface to which a surface of the conductor wiring closely adheres, and a second principal surface on a side opposite to the first principal surface;
a magnetic layer positioned on a side of the insulating layer where the second principal surface is present; and
a conductor layer positioned on a side of the magnetic layer opposite to the insulating layer,
wherein the surface or the first principal surface has an arithmetic mean roughness of 0.1 µm or greater and 5.0 µm or less.

2. The wiring board according to claim 1,
wherein the magnetic layer has a thickness of 0.1 µm or greater and 100 µm or less.

3. The wiring board according to claim 1 or 2,
wherein the magnetic layer has a relative magnetic permeability of 1.5 or greater at a frequency of 30 GHz or higher.

4. The wiring board according to any one of claims 1 to 3,
wherein the magnetic layer has a part that is wider than the conductor wiring.

5. The wiring board according to any one of claims 1 to 4,
wherein the insulating layer has a part that is equal to or smaller than the magnetic layer in thickness.

6. The wiring board according to any one of claims 1 to 5, further comprising:
a second insulating layer between the magnetic layer and the conductor layer.
